# EUROPEAN PATENT APPLICATION

(11) **EP 4 534 737 A1**
(43) Date of publication of application: **09.04.2025**
(21) Application number: 23814790.4
(22) Date of filing: 13.04.2023
(51) Int. Cl.: C30B 15/02, C30B 29/06, C30B 15/20, C30B 15/00

(54) **LIQUID MATERIAL FEEDING DEVICE, SINGLE CRYSTAL FURNACE, AND MATERIAL FEEDING METHOD AND PULLING METHOD THEREOF**

(30) Priority: 31.05.2022 CN 202210615372; 31.05.2022 CN 202210612850
(71) Applicant: Longi Green Energy Technology Co., Ltd., Xi'an, Shaanxi 710100 (CN)
(72) Inventor: DONG, Sheng, Shaanxi 710100 (CN); LI, Qiao, Shaanxi 710100 (CN); DENG, Hao, Shaanxi 710100 (CN)
(74) Representative: Pfenning, Meinig & Partner mbB
(86) International application number: PCT/CN2023/088052
(87) International publication number: WO 2023/231597

(57) **Abstract**

This application provides a liquid feeding device, a single crystal furnace and a supplying method therefor, and a crystal pulling method, and relates to the field of crystal growth. The liquid feeding device includes a melting device and a supplying device. The melting device is connected to an exterior of the single crystal furnace. The melting device includes a melting cavity and a heating component. The heating component melts solid material in the melting cavity into liquid material, and conveys the liquid material to a crucible. The supplying device is configured to convey solid material into the melting cavity. This application aims to resolve a problem that liquid silicon material in a crucible oscillates and affects growth of crystal ingots when solid silicon material is fed into the crucible during crystal growth.

## Description

### CROSS-REFERENCE TO RELATED APPLICATIONS

This application claims priorities to Chinese Patent Application No. 202210612850.1, field with the China National Intellectual Administration Property on May 31, 2022 and entitled "LIQUID FEEDING DEVICE, AND SINGLE CRYSTAL FURNACE AND SUPPLYING METHOD THEREFOR", and Chinese Patent Application No. 202210615372.X, filed with the China National Intellectual Administration Property on May 31, 2022 and entitled "CRYSTAL PULLING PRODUCTION APPARATUS AND CRYSTAL PULLING METHOD", which are incorporated herein by reference in their entities.

### TECHNICAL FIELD

This application relates to the field of crystal growth technologies, and in particular, to a liquid feeding device, a single crystal furnace and a supplying method therefor, and a crystal pulling method.

### BACKGROUND

Currently, in industrial production of monocrystalline silicon, monocrystalline silicon is grown by using a continuous Czochralski (CCZ) method. When the monocrystalline silicon is grown by using the CCZ method, silicon material needs to be continuously supplied into a crucible through a feeding device.

Generally, the supplied silicon material is solid silicon material. The feeding device feeds the solid silicon material into an edge of a crucible in a single crystal furnace. The solid silicon material is melted into liquid silicon material in the crucible in the single crystal furnace, during which, however, monocrystalline ingots are being pulled in a central region of the crucible in the single crystal furnace. Therefore, when the solid material is fed into the crucible, falling of the solid material caused by gravity generates oscillation in the original liquid material in the crucible, resulting in formation of ripples. The ripples extend from a periphery of the crucible to a center of the crucible, resulting in breakage or poor growth in a growth process of the monocrystalline ingots, which reduces a success rate of crystal pulling of the monocrystalline silicon ingots.

### SUMMARY

An objective of this application is to provide a liquid feeding device, a single crystal furnace and a supplying method therefor, and a crystal pulling method, to reduce a degree of oscillation of liquid material in a crucible during feeding.

To achieve the foregoing objective, this application provides the following technical solutions:
A liquid feeding device, used in a single crystal furnace, includes:
a melting device, including a melting cavity and a heating component, where the heating component melts solid material in the melting cavity into liquid material; and
a supplying device, configured to convey solid material into the melting cavity.

Compared with the related art, in the liquid feeding device provided in this application, the supplying device conveys solid material into the melting cavity, the heating component heats and melts the solid material in the melting cavity into liquid material, and conveys the liquid material into the crucible in the single crystal furnace. In this way, solid material can be first converted into liquid material in the melting cavity, and then the liquid material is fed into the crucible for crystal pulling. Because when the liquid material in the melting cavity is fed into in the crucible in the single crystal furnace, a degree of oscillation caused is small, amplitudes of ripples generated are small, and impact on growth of monocrystalline silicon is small, a success rate of crystal pulling is improved, so that monocrystalline silicon with good performance can be grown.

Optionally, in the liquid feeding device, the liquid feeding device further includes:
a temperature detection device, configured to detect a temperature in the melting cavity; and
a first controller, connected to the temperature detection device and the supplying device and/or the heating component, and configured to adjust a supply of the supplying device and/or a power of the heating component in real time based on a temperature fed back by the temperature detection device;
   or
a first weight detection device, configured to detect a weight of the melt in the melting cavity; and
a second controller, connected to the first weight detection device and the supplying device and/or the heating component, and configured to adjust a supply of the supplying device and/or a power of the heating component in real time based on a weight fed back by the first weight detection device;
   or
a temperature detection device, configured to detect a temperature in the melting cavity; and
a first weight detection device, configured to detect a weight of the melt in the melting cavity; and
a third controller, connected to the temperature detection device, the first weight detection device, and the supplying device and/or the heating component, and configured to adjust a supply of the supplying device and/or a power of the heating component in real time based on a temperature fed back by the temperature detection device and a weight fed back by the first weight detection device. Through such arrangement, a supply of the supplying device and/or a power of the heating component can be adjusted in real time based on the temperature and the weight of the melt in the melting cavity. By adjusting the supply of the supplying device for the melting cavity, a supply of liquid material conveyed from the melting cavity into the crucible can be adjusted. By adjusting a power of the heating component, a melting rate of solid material in the melting cavity can be adjusted, and then a supply of liquid material conveyed from the melting cavity into the crucible is adjusted, so that a liquid level of liquid material in the crucible can be further adjusted by adjusting the supply of the liquid material conveyed from the melting cavity into the crucible, thereby preventing problems, such as breakage and poor growth, of monocrystalline silicon caused when the liquid level of the liquid material in the crucible vertically fluctuates, and improving growth quality of the monocrystalline silicon.

Optionally, the liquid feeding device further includes a cooling device, where the cooling device is arranged on a side portion or a bottom portion of the melting cavity. Through such arrangement, the melting cavity can be cooled through the cooling device, thereby increasing a cooling speed of the melting cavity.

Optionally, the liquid feeding device further includes:
a flow control system, configured to control a flow of the cooling device; and
a fourth controller, connected to the flow control system and the supplying device and/or the heating component, and configured to adjust a supply of the supplying device and/or a power of the heating component and/or a flow of the flow control system in real time based on a temperature in the melting cavity and/or a weight of the melt in the melting cavity. Through such arrangement, it is convenient to control, by adjusting the supply of the supplying device, the power of the heating component, and/or the flow of the flow control system, liquid material conveyed from the melting cavity to the crucible.

Optionally, in the liquid feeding device, the melting device further includes a conduit, where the conduit is connected to the melting cavity, and an end of the conduit and/or an end of the melting cavity close to the single crystal furnace is inclined downward relative to an other end thereof. Through such arrangement, it is convenient for liquid material in the melting cavity and the conduit to flow into the crucible under the action of gravity.

Optionally, in the foregoing liquid feeding device, the melting cavity and the conduit are an integral structure, including a melting section and an export section, where the melting section includes a material inlet for receiving solid material, the export section includes a material outlet for extending into the single crystal furnace, and the material outlet is provided with a notch for preventing the melt from flowing back along a wall of the conduit. Through such arrangement, structures of the conduit and the melting cavity are optimized, so that liquid material is enabled to flow into the single crystal furnace along the wall of the conduit while the melt can be prevented, by using the notch, from flowing back along the wall of the conduit.

Optionally, in the liquid feeding device, the melting section and the export section are both in a groove shape. Alternatively, the melting section and/or the export section is partially tubular, and the melting section includes the material inlet in a groove shape. Through such arrangement, when the melting section and the export section are both in a groove shape, solid material can be received and stored by using the groove-shaped melting section. In addition, the melting section and the export section have a simple structure, leading to convenient processing. When the melting section and/or the export section is partially tubular, and the melting section includes the material inlet in a groove shape, not only solid material can be received by using the material inlet in a groove shape, but also strength of the melting section or the export section can be increased by using the tubular structure.

Optionally, in the liquid feeding device, the melting device further includes a telescopic control mechanism configured to control the conduit and/or the melting cavity to perform telescopic movement. Through such arrangement, the conduit and/or the melting cavity are controlled by the telescopic control mechanism to telescope, to prevent the conduit and the melting cavity from affecting operations, such as crystal pulling, performed in the single crystal furnace while ensuring that the conduit can extend into the crucible in the single crystal furnace for feeding.

Optionally, in the liquid feeding device, the melting device further includes a first guide pipe, configured to guide the solid material from the supplying device into the melting cavity, where an upper end of the first guide pipe is funnel-shaped and has a surrounding plate arranged to receive the solid material conveyed by the supplying device and prevent the solid material from escaping from the first guide pipe. Through such arrangement, heat radiation generated by the melting device can be prevented from heating the solid material in the supplying device.

Optionally, in the liquid feeding device, the melting device further includes a second guide pipe having high temperature resistance, where one end of the second guide pipe is connected to the first guide pipe, and an other end thereof is in communication with the melting cavity, to guide the solid material in the first guide pipe into the melting cavity. Through such arrangement, the first guide pipe is in communication with the melting cavity by using the second guide pipe having high temperature resistance, to prevent the temperature environment of the melting cavity from affecting performance of the first guide pipe.

This application further provides a single crystal furnace, including the liquid feeding device according to the foregoing solution.

Compared with the related art, beneficial effects of the single crystal furnace provided in this application are the same as the beneficial effects of the liquid feeding device according to the foregoing technical solutions, and details are not described herein again.

Optionally, in the single crystal furnace, the single crystal furnace is integrally connected to the melting device. Through such arrangement, it is ensured that the single crystal furnace and the melting device are located in a same vacuum environment, leading to a good sealing effect.

Optionally, in the single crystal furnace, the single crystal furnace further includes an isolation device, the melting device includes a housing integrally formed with the single crystal furnace and a sealed cavity located in the housing, the melting cavity and the heating component are located in the sealed cavity, the housing includes a first opening in communication with the single crystal furnace and a second opening in communication with the supplying device, and the isolation device is arranged at a position of the second opening, and configured to close the second opening when the supplying device is removed, to cause the single crystal furnace and the melting device to be still in a sealed environment when the supplying device is removed. Through such arrangement, when the supplying device is removed, the second opening can be closed by using the isolation device, so that the single crystal furnace and the melting device are still in a sealed environment when the supplying device is removed, thereby preventing an external environment from affecting growth of monocrystalline silicon.

This application further provides a supplying method for a single crystal furnace. The single crystal furnace according to the foregoing solution is used. The method includes:
conveying solid material into the melting device through the supplying device; and
melting the solid material through the melting device to generate liquid material, and conveying the liquid material into a crucible in the single crystal furnace to supply the liquid material.

Compared with the related art, beneficial effects of the supplying method for a single crystal furnace provided in this application are the same as the beneficial effects of the single crystal furnace provided in the foregoing technical solutions, and details are not described herein again.

Optionally, in the foregoing supplying method for a single crystal furnace, a supply of the supplying device or a power of the heating component is adjusted in real time based on a temperature in the melting device;
or
a supply of the supplying device or a power of the heating component is adjusted in real time based on a weight of the melt in the melting device;
   or
a supply of the supplying device or a power of the heating component is adjusted in real time based on a temperature in the melting device and a weight of the melt in the melting device. Through such arrangement, a volume of liquid material conveyed from the melting cavity to the crucible can be controlled, so that a liquid level of liquid material in the crucible is controlled, thereby preventing problems, such as breakage and poor growth, of monocrystalline silicon caused when the liquid level of the liquid material in the crucible vertically fluctuates, and improving growth quality of the monocrystalline silicon.

Optionally, in the foregoing supplying method for a single crystal furnace, the cooling device is arranged on a side portion or a bottom portion of the melting cavity. Through such arrangement, the melting cavity is cooled through the cooling device, so that a temperature in the melting cavity can be further accurately controlled, thereby accurately controlling the liquid level of the liquid material in the crucible.

Optionally, in the foregoing supplying method for a single crystal furnace, a flow of the cooling device is adjustable. The supply of the supplying device, the power of the heating component, and/or the flow of the cooling device is adjusted in real time based on the temperature in the melting device and the weight of the melt in the melting device. Through such arrangement, a volume of liquid material conveyed from the melting cavity into the crucible can be accurately controlled by controlling a supply of the supplying device, a power of the heating component, and/or a flow of the cooling device, thereby accurately controlling a liquid level of the liquid material in the crucible.

This application provides a crystal pulling production apparatus and a crystal pulling method. The crystal pulling production apparatus has beneficial effects of good quality of crystal pulling and high production efficiency.

According to a first aspect, this application provides a crystal pulling production apparatus. The crystal pulling production apparatus includes a single crystal furnace and a feeding component. The feeding component is located outside the single crystal furnace, and configured to feed silicon material into the single crystal furnace. A gas inlet pipe is arranged on the feeding component. The gas inlet pipe is configured to introduce cleaning gas. The cleaning gas enters the single crystal furnace through the feeding component.

In a case that the technical solution is used, in a process in which the feeding component performs feeding to the single crystal furnace, or before crystal pulling production, or during entire crystal pulling production, cleaning gas may be continuously introduced into the single crystal furnace by using the gas inlet pipe. As the cleaning gas is exhausted from the exhaust port of the single crystal furnace, the cleaning gas can carry away the dust and silicon vapor, thereby reducing dust and silicon vapor falling on the surface of the liquid silicon material in the single crystal furnace, reducing dust adhered to an inner wall of the apparatus, reducing adverse impact of dust and silicon vapor on quality of crystal pulling, and increasing a success rate of crystal pulling.

In a possible implementation, the feeding component includes a melting device. The melting device is configured to feed liquid silicon material into the single crystal furnace. The gas inlet pipe includes a second gas inlet pipe and/or a third gas inlet pipe arranged on the melting device. In a case that the technical solution is used, cleaning gas introduced through the second gas inlet pipe and/or the third gas inlet pipe can be used to carry away dust generated when the solid silicon material is fed and silicon vapor generated when the solid silicon material is melted into the liquid silicon material.

In a possible embodiment, the melting device includes a sealed cavity, a melting cavity, and a heating component. The melting cavity is configured to hold solid silicon material and/or liquid silicon material. The melting cavity is provided with a material outlet in communication with the single crystal furnace. The melting cavity and the heating component are both located in the sealed cavity. The heating component is configured to heat and melt silicon material in the melting cavity. In a case that the technical solution is used, when the melting cavity holds solid silicon material, the heating component may melt the solid silicon material into a liquid state, and when the melting cavity holds liquid silicon material, the heating component may heat the solid silicon material to maintain a liquid state. The sealed cavity can achieve heat insulation and sealing, and can further avoid scalding caused by accidental touching the heating component and the melting cavity.

In an example, the second gas inlet pipe is communicatively arranged at a top portion of the sealed cavity, and a gas outlet of the second gas inlet pipe corresponds to the material inlet of the melting cavity. It is convenient for cleaning gas introduced through the second gas inlet pipe to enter the material inlet, to carry dust and silicon vapor away from the melting device.

In an example, the melting device further includes a heat insulation member located in the sealed cavity. The heat insulation member is provided with an inner cavity. The melting cavity and the heating component are both located in the inner cavity. The heat insulation member is provided with an avoidance hole. The avoidance hole corresponds to the material inlet of the melting cavity. In a case that the technical solution is used, silicon material enters the melting cavity from the avoidance hole. The heat insulation member can achieve heat insulation, which helps solid silicon material in the melting cavity to be quickly and fully heated and melted into liquid silicon material by the heating component, or helps keep liquid silicon material in the melting cavity in a liquid state.

In an example, the third gas inlet pipe is communicatively arranged on a side portion of the sealed cavity. The heat insulation member is provided with a vent hole. An inner end of the vent hole is in communication with the material inlet of the melting cavity, and an outer end thereof corresponds to a gas outlet of the third gas inlet pipe. In a case that the technical solution is used, cleaning gas introduced through the third gas inlet pipe enters the material inlet of the melting cavity through the vent hole, so that the cleaning gas can flush an inner wall of the melting cavity, carry silicon vapor and dust away from the melting cavity, and improve cleanliness in the melting cavity.

In a possible implementation, the crystal pulling production apparatus further includes a cooling device. The cooling device is arranged on a side portion or a bottom portion of the sealed cavity. In a case that the technical solution is used, the cooling device can cool down a side wall of the melting cavity in the sealed cavity. A cooling capacity of the cooling device can be adjusted, to keep the melting cavity in a proper temperature range, thereby avoiding softening of the melting cavity caused by an excessively high heating temperature while ensuring that silicon material in the melting cavity has a temperature higher than a melting point of the silicon material and can be quickly melted.

In a possible implementation, the feeding component includes a supplying device. The supplying device is configured to feed solid silicon material into the single crystal furnace, and the gas inlet pipe includes a first gas inlet pipe located on the supplying device. In a case that the technical solution is used, cleaning gas introduced through the first gas inlet pipe first enters the supplying device, and can blow solid silicon material in the supplying device to carry away dust adhered to the solid silicon material. Dust generated in a process in which the solid silicon material is fed into the single crystal furnace and silicon vapor generated during melting of the solid silicon material in the single crystal furnace may also be carried away by the cleaning gas introduced through the first gas inlet pipe, and be exhausted from the single crystal furnace together with the cleaning gas.

In a possible embodiment, the supplying device includes a feed bin and a material conveying device. The material conveying device has two ends in communication with the feed bin and the single crystal furnace respectively, and is configured to convey solid silicon material from the feed bin to the single crystal furnace. The first gas inlet pipe is communicatively arranged at a side portion of the feed bin, and the cleaning gas enters the single crystal furnace through the material conveying device. In a case that the technical solution is used, in a process in which solid silicon material is placed in the material conveying device and enters the single crystal furnace from the material conveying device, generated dust may be carried by cleaning gas and exhausted from the single crystal furnace, so that dust falling on a surface of liquid silicon material in the single crystal furnace can be reduced, thereby reducing adverse impact on quality of crystal pulling. Silicon vapor generated when solid silicon material is melted into a liquid state in the single crystal furnace may also be carried away by cleaning gas.

In a possible implementation, the feeding component includes a supplying device and a melting device. The supplying device conveys solid silicon material to the melting device. The melting device melts the solid silicon material into liquid silicon material and conveys the liquid silicon material into the single crystal furnace. The gas inlet pipe includes at least one of a first gas inlet pipe, a second gas inlet pipe, and a third gas inlet pipe. The first gas inlet pipe is located on the supplying device, and the second gas inlet pipe and the third gas inlet pipe are located on the melting device. In a case that the technical solution is used, cleaning gas introduced into any one of the foregoing three gas inlet pipes can carry away dust generated during conveying of solid silicon material and silicon vapor generated when the solid silicon material is melted into liquid silicon material.

In a possible embodiment, the melting device further includes an isolation device. The melting device is provided with an inlet. The isolation device is mounted at the inlet. When the isolation device is open, the supplying device extends into the melting device through the inlet. When the supplying device exits the melting device, the isolation device is closed. In **a** case that the technical solution is used, after completing conveying of solid silicon material, the supplying device can be caused to exit the melting device, thereby reducing adverse impact of a high temperature in the melting device on the supplying device.

In a possible implementation, the crystal pulling production apparatus further includes a vacuum generation device. Both the single crystal furnace and the cooling gas outlet pipe are connected to the vacuum generation device.

According to a second aspect, based on the foregoing crystal pulling production apparatus, this application further provides a crystal pulling method. The crystal pulling method includes:
closing the crystal pulling production apparatus, to make the crystal pulling production apparatus in a preset low-pressure state;
continuously introducing cleaning gas by using the gas inlet pipe, and continuously exhausting the cleaning gas from the single crystal furnace, to maintain the preset low-pressure state;
feeding silicon material to the single crystal furnace by using the feeding component, to perform crystal pulling; and
after the crystal pulling is completed, stopping introducing the cleaning gas.

In a case that the foregoing technical solution is used, by continuously introducing cleaning gas until crystal pulling is completed, dust and silicon vapor generated during the crystal pulling can be carried away as much as possible, thereby reducing adverse impact on the crystal pulling, and improving quality and a success rate of the crystal pulling.

In an example, the vacuum generation device may be connected to the single crystal furnace to continuously pump gas in the crystal pulling production apparatus, to keep the crystal pulling production apparatus in a preset low-pressure state, so that under the action of the vacuum generation device, cleaning gas is continuously exhausted from the single crystal furnace to carry away dust and silicon vapor, thereby cleaning an interior of the crystal pulling production apparatus.

In an example, if the crystal pulling production apparatus includes at least one of the first gas inlet pipe, the second gas inlet pipe, and the third gas inlet pipe, when cleaning gas needs to be introduced, all the gas inlet pipes may be used to introduce the cleaning gas simultaneously, and a large flow of cleaning gas can carry away dust and silicon vapor as much as possible.

In an example, when the supplying device exits the melting device, communication between the supplying device and the single crystal furnace is cut off, and cleaning gas introduced through the first gas inlet pipe cannot enter the single crystal furnace. Therefore, the first gas inlet pipe needs to be closed.

In an example, if the crystal pulling production apparatus includes a cooling device, when the melting cavity is heated by using the heating component, the melting cavity is cooled by using the cooling device, so that the melting cavity is in a proper temperature range, to avoid softening of the melting cavity caused by an excessively high heating temperature.

### BRIEF DESCRIPTION OF THE DRAWINGS

The accompanying drawings described herein are used to provide a further understanding of this application, and form a part of this application. Exemplary embodiments of this application and description thereof are used to explain this application, and do not constitute any inappropriate limitation to this application. In the accompanying drawings:
FIG. 1 is a schematic diagram 1 of a single crystal furnace and a liquid feeding device according to an embodiment of this application;
FIG. 2 is a schematic diagram 2 of a single crystal furnace and a liquid feeding device according to an embodiment of this application;
FIG. 3 is a schematic diagram 3 of a single crystal furnace and a liquid feeding device according to an embodiment of this application;
FIG. 4 is a schematic diagram of a first guide pipe according to an embodiment of this application;
FIG. 5 is a schematic diagram of a second guide pipe according to an embodiment of this application;
FIG. 6 is a schematic diagram of a baffle plate according to an embodiment of this application;
FIG. 7 is a schematic diagram 1 of a melting cavity and a conduit being an integral structure according to an embodiment of this application;
FIG. 8 is a schematic diagram 2 of a melting cavity and a conduit being an integral structure according to an embodiment of this application;
FIG. 9 is a schematic diagram of a crystal pulling production apparatus according to an embodiment of this application; and
FIG. 10 is a partial three-dimensional cross-sectional view of a liquid feeding device according to an embodiment of this application.

Reference numerals:
1-single crystal furnace, 2-crucible, 3-melting device, 30-heat insulation member, 301-vent hole, 31-melting cavity, 311-material inlet, 312-melting section, 313-export section, 32-heating component, 33-temperature detection device, 34-cooling pipe, 35-first guide pipe, 351-pipe body, 352-funnel portion, 353-surrounding plate, 36-second guide pipe, 361-first positioning protrusion, 37-conduit, 38-housing, 39-sealed cavity, 4-supplying device, 401-feeding position, 402-dropping position, 41-feed bin, 42-material conveying device, 421-carrying component, 422-driving component, 423-second weight detection device, 43-hopper, 431-discharge port, 5-baffle plate, 51-flow hole, 52-second positioning protrusion, 6-isolation device, 61-first gas inlet pipe, 62-second gas inlet pipe, 63-third gas inlet pipe, 7-telescopic control mechanism, 71-cooling gas inlet pipe, 72-cooling gas outlet pipe, 8-base, and 9-vacuum generation device.

### DETAILED DESCRIPTION

To make the technical problems to be resolved by, the technical solutions, and the beneficial effects of this application clearer and more comprehensible, the following further describes this application in detail with reference to the accompanying drawings and embodiments. It should be understood that, the specific embodiments described herein are merely used for describing this application and are not used for limiting this application.

It should be noted that when an element is described as being "fixed on" or "arranged on" another element, the element may be directly located on the another element or indirectly located on the another element. When an element is described as being "connected to" another element, the element may be directly connected to the another element or indirectly connected to the another element.

In addition, the terms "first" and "second" are used for descriptive purposes only and are not to be construed as indicating or implying relative importance or implicitly indicating the number of technical features indicated. Therefore, a feature defined by "first" or "second" may explicitly indicate or implicitly include one or more features. In the description of this application, "a plurality of" means two or more, unless otherwise definitely and specifically limited. "Several" means one or more, unless otherwise definitely and specifically limited.

In the description of this application, it should be understood that orientation or position relationships indicated by the terms such as "on", "below", "front", "rear", "left", "right", and the like are based on orientation or position relationships shown in the accompanying drawings, and are used only for ease and brevity of illustration of this application and description, rather than indicating or implying that the mentioned device or element needs to have a particular orientation or needs to be constructed and operated in a particular orientation. Therefore, such terms should not be construed as a limitation to this application.

In the description of this application, it should be noted that, unless otherwise explicitly specified or defined, the terms such as "install", "connect", and "connection" should be understood in a broad sense. For example, the connection may be a fixed connection, a detachable connection, or an integral connection; or the connection may be a mechanical connection or an electrical connection; or the connection may be a direct connection, an indirect connection through an intermediary, internal communication between two elements, or an interactive relationship between two elements. Persons of ordinary skill in the art can understand specific meanings of the terms in this application based on specific situations.

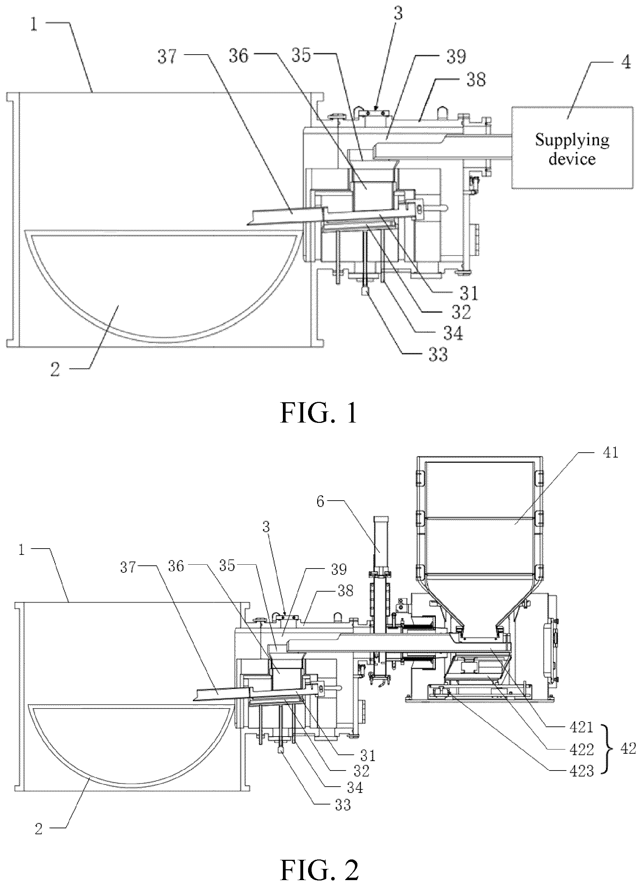

Referring to FIG. 1, a liquid feeding device provided in this embodiment of this application includes a melting device 3 and a supplying device 4. The melting device 3 includes a melting cavity 31 and a heating component 32. The supplying device 4 is configured to convey solid material into the melting cavity 31, and the heating component 32 melts the solid material in the melting cavity 31 into liquid material. The supplying device 4 in this embodiment is a device that can supply material into the melting device 3. The heating component 32 is a device for heating. In this embodiment, the heating component 32 is preferably a graphite heater that can heat and melt silicon material with a high melting point, and is preferably a wrapping heating component 32 that can improve heating efficiency and a heating effect by wrapping around the melting cavity 31. The melting cavity 31 is a cavity that can accommodate material and melt the material, and a shape of the cavity is variable. In this embodiment, both the solid material and the liquid material are preferably silicon materials. In addition, in this embodiment, preferably, hot zone felt is wrapped outside the heating component 32 for thermal insulation.

During specific implementation, first, the supplying device 4 conveys solid material into the melting cavity 31 of the melting device 3, second, the heating component 32 heats and melts the solid material in the melting cavity 31 into liquid material, and finally, the melting device conveys the liquid material into a crucible 2 to supply the liquid material.

It can be learned from a structure and a specific implementation process of the foregoing liquid feeding device that, the supplying device 4 conveys solid material into the melting cavity 31, the heating component 32 heats and melts the solid material in the melting cavity 31 into liquid material, and conveys the liquid material into the crucible 2 in the single crystal furnace. In this way, solid material can be first converted into liquid material in the melting cavity 31, and then the liquid material is fed into the crucible 2 for crystal pulling. Because when the liquid material in the melting cavity 31 is fed into liquid material in the crucible 2, a degree of oscillation caused is small, amplitudes of ripples generated are small, and impact on growth of monocrystalline silicon is small, a success rate of crystal pulling is improved, so that the single crystal furnace 1 can pull crystal to grow monocrystalline silicon with good performance.

In a possible implementation, the liquid feeding device in this embodiment further includes controlling a temperature in the melting cavity 31 and/or a weight of the melt in the melting cavity 31 by controlling a supply of the supplying device 4, a power of the heating component 32, and/or a flow of a cooling device, to effectively control a temperature in the crucible in the single crystal furnace and a weight of the melt entering the crucible, so that the fed material does not cause large oscillation when entering the crucible, and does not affect growth of monocrystalline silicon. Details are described with reference to the following embodiments:

### Embodiment 1:

In this embodiment, the liquid feeding device further includes a temperature detection device 33 and a first controller. The temperature detection device 33 is configured to detect a temperature in the melting cavity 31. The first controller is connected to the temperature detection device 33 and the supplying device 4 and/or the heating component 32, and configured to adjust a supply of the supplying device 4 and/or a power of the heating component 32 in real time based on a temperature fed back by the temperature detection device 33. With this structure, the temperature detection device 33 detects a temperature in the melting cavity 31, the first controller receives a temperature fed back by the temperature detection device 33, and adjusts a supply of the supplying device 4 and/or a power of the heating component 32 in real time based on the temperature. By adjusting the supply of the supplying device 4 for the melting cavity 31, a supply of liquid material conveyed from the melting cavity 31 into the crucible 2 can be adjusted. Alternatively, by adjusting a power of the heating component 32, a melting rate of solid material in the melting cavity 31 is adjusted, and then a supply of liquid material conveyed from the melting cavity 31 into the crucible 2 is adjusted, so that a liquid level of liquid material in the crucible 2 can be controlled by controlling a volume of the liquid material in the crucible 2, thereby preventing problems, such as breakage and poor growth, of monocrystalline silicon caused when the liquid level of the liquid material in the crucible 2 vertically fluctuates, and improving growth quality of the monocrystalline silicon. In this embodiment, the temperature detection device 33 is preferably a temperature sensor.

Specifically, this embodiment includes presetting a first temperature threshold for the first controller. For example, the first temperature threshold may range from 1400 to 2000 degrees, and specifically, may be 1400 degrees, 1500 degrees, 1600 degrees, 1700 degrees, 1800 degrees, 1900 degrees, or 2000 degrees. A specific value of the first temperature threshold may be set by persons skilled in the art based on their experience. A PC control terminal of the single crystal furnace may be connected to the temperature detection device 33 and the first controller, so that after a temperature collected by the temperature detection device 33 is fed back to the PC control terminal of the single crystal furnace, the PC control terminal may send an operation instruction to the first controller based on the preset first temperature threshold. When the temperature fed back by the temperature detection device 33 is greater than the first temperature threshold, the supply of the supplying device 4 is adjusted and reduced in real time by the first controller, or the power of the heating component 32 is reduced in real time by the first controller. When the temperature fed back by the temperature detection device 33 is greater than the first temperature threshold, a temperature in the melting cavity 31 is excessively high, a melting rate of material in the melting cavity 31 is high, the melting cavity 31 supplies too much liquid material to the crucible 2, and a liquid level of liquid material in the crucible 2 rises. In this case, by controlling, by the first controller, a supply of the supplying device 4 to decrease, a volume of material in the melting cavity 31 can be reduced, and then a volume of liquid material conveyed from the melting cavity 31 into the crucible 2 can be reduced, so that a volume of liquid material in the crucible 2 decreases to reach stability, to ensure that a liquid level of the liquid material in the crucible 2 remains stable. Alternatively, by reducing a power of the heating component 32, a melting rate of material in the melting cavity 31 is reduced, and then a volume of liquid material conveyed from the melting cavity 31 into the crucible 2 is reduced, so that a volume of liquid material in the crucible 2 decreases to reach stability, to ensure that a liquid level of the liquid material in the crucible 2 remains stable, thereby preventing problems, such as breakage and poor growth, of monocrystalline silicon caused when the liquid level of the liquid material in the crucible 2 vertically fluctuates, and improving growth quality of the monocrystalline silicon.

In an optional manner, in this embodiment, the first controller may preset a plurality of levels of temperature thresholds, for example, may set a first temperature threshold and a second temperature threshold. The first temperature threshold may range from 1400 to 1500 degrees, and the second temperature threshold may range from 1500 to 2000 degrees. Specific values of the first temperature threshold and the second temperature threshold may be set by persons skilled in the art based on their experience. A PC control terminal of the single crystal furnace may be connected to the temperature detection device 33 and the first controller, so that after a temperature collected by the temperature detection device 33 is fed back to the PC control terminal of the single crystal furnace, the PC control terminal may send an operation instruction to the first controller based on the preset first temperature threshold and second temperature threshold. The first controller adjusts the supply of the supplying device 4 and/or the power of the heating component 32 in real time based on the temperature fed back by the temperature detection device 33. Specifically, the supply of the supplying device 4 and the power of the heating component 32 are related to at least two temperature thresholds, and different temperature thresholds correspond to different supplies of the supplying device 4 or different powers of the heating component 32. The first controller accurately adjusts the supply of the supplying device 4 and the power of the heating component 32 by comparing relationships between the temperature fed back by the temperature detection device 33 and the at least two temperature thresholds, to implement multi-level control of the power of the heating component 32 and multi-level control of the supply of the supplying device 4, and improve temperature control accuracy of the heating component 32 and supply control accuracy of the supplying device 4, so that the first controller can accurately control a liquid level of liquid material in the crucible 2, thereby ensuring that monocrystalline silicon has good growth quality.

### Embodiment 2:

This embodiment differs from Embodiment 1 in that: In this embodiment, the liquid feeding device includes a first weight detection device and a second controller. The first weight detection device is configured to detect a weight of the melt in the melting cavity 31. The second controller is connected to the first weight detection device and the supplying device 4 and/or the heating component 32, and configured to adjust a supply of the supplying device 4 and/or a power of the heating component 32 in real time based on a weight fed back by the first weight detection device. With this structure, the first weight detection device detects a weight of the melt in the melting cavity 31, the second controller receives a weight value fed back by the first weight detection device, and adjusts a supply of the supplying device 4 and/or a power of the heating component 32 in real time based on the weight value. By adjusting the supply of the supplying device 4 for the melting cavity 31, a supply of liquid material conveyed from the melting cavity 31 into the crucible 2 can be adjusted. By adjusting a power of the heating component 32, a melting rate of solid material in the melting cavity 31 can be adjusted, and then a supply of liquid material conveyed from the melting cavity 31 into the crucible 2 is adjusted, so that a liquid level of liquid material in the crucible 2 can be controlled by controlling a volume of the liquid material in the crucible 2, thereby preventing problems, such as breakage and poor growth, of monocrystalline silicon caused when the liquid level of the liquid material in the crucible 2 vertically fluctuates, and improving growth quality of the monocrystalline silicon.

Specifically, this embodiment includes presetting a first weight threshold for the second controller. For example, the first weight threshold may range from 50 g to 500 g, and specifically, may be 50 g, 60 g, 70 g, 80 g, 90 g, 100 g, 200 g, 300 g, 400 g, or 500 g. A specific value of the first weight threshold may be set by persons skilled in the art based on their experience. The first weight threshold is set on a PC control terminal of the single crystal furnace. The PC control terminal of the single crystal furnace is connected to the first weight detection device and the second controller, so that when a weight fed back by the first weight detection device reaches the PC control terminal, the PC control terminal may send an operation instruction to the second controller based on the preset first weight threshold. When the weight fed back by the first weight detection device is greater than the first weight threshold, the supply of the supplying device 4 is adjusted and reduced in real time by the second controller, or the power of the heating component 32 is reduced in real time by the second controller. When the weight fed back by the first weight detection device is greater than the first weight threshold, the melt in the melting cavity is 31 is excessive, material supplied by the supplying device 4 to the melting cavity 31 is much, or the power of the heating component 32 is low. In this case, by controlling, by the second controller, a supply of the supplying device 4 to decrease, a volume of material in the melting cavity 31 can be reduced, to ensure stable changing of a volume of liquid material in the melting cavity 31, thereby ensuring that an amount of material conveyed from the melting cavity 31 into the crucible 2 is in a stable state. Alternatively, by increasing a power of the heating component 32, a melting rate of material in the melting cavity 31 is raised, and then a volume of liquid material conveyed from the melting cavity 31 into the crucible 2 is increased, so that a volume of liquid material in the crucible 2 is stable, to ensure that a liquid level of the liquid material in the crucible 2 remains stable, thereby preventing problems, such as breakage and poor growth, of monocrystalline silicon caused when the liquid level of the liquid material in the crucible 2 vertically fluctuates, and improving growth quality of the monocrystalline silicon.

In an optional manner, in this embodiment, the second controller may preset a plurality of levels of weight thresholds, for example, may set a first weight threshold and a second weight threshold. The first weight threshold may range from 50 g to 200 g, and the second weight threshold may range from 200 g to 500 g. Specific values of the first weight threshold and the second weight threshold may be set by persons skilled in the art based on their experience. A PC control terminal of the single crystal furnace may be connected to the first weight detection device and the second controller, so that after a weight collected by the first weight detection device is fed back to the PC control terminal of the single crystal furnace, the PC control terminal may send an operation instruction to the second controller based on the preset first weight threshold and second weight threshold. The second controller adjusts the supply of the supplying device 4 and/or the power of the heating component 32 in real time based on the weight fed back by the first weight detection device. Specifically, the supply of the supplying device 4 and the power of the heating component 32 are related to at least two weight thresholds, and different weight thresholds correspond to different supplies of the supplying device 4 and different powers of the heating component 32. The second controller accurately adjusts the supply of the supplying device 4 and the power of the heating component 32 by comparing relationships between the weight fed back by the first weight detection device and the at least two weight thresholds, to implement multi-level control of the power of the heating component 32 and multi-level control of the supply of the supplying device 4, and improve temperature control accuracy of the heating component 32 and supply control accuracy of the supplying device 4, so that the second controller can accurately control a liquid level of liquid material in the crucible 2, thereby ensuring that monocrystalline silicon has good growth quality.

### Embodiment 3:

This embodiment differs from Embodiment 1 in that: In this embodiment, the liquid feeding device includes a temperature detection device 33, a first weight detection device, and a third controller. The temperature detection device 33 is configured to detect a temperature in the melting cavity 31. The first weight detection device is configured to detect a weight of the melt in the melting cavity 31. The third controller is connected to the temperature detection device 33, the first weight detection device, and the supplying device 4 and/or the heating component 32, and configured to adjust a supply of the supplying device 4 and/or a power of the heating component 32 in real time based on a temperature fed back by the temperature detection device 33 and a weight fed back by the first weight detection device. With this structure, the third controller can adjust the supply of the supplying device 4 and/or the power of the heating component 32 in real time based on detected values of both the temperature detection device 33 and the first weight detection device, to improve accuracy of control, thereby fully ensuring stability of a liquid level of liquid material in the crucible 2.

Specifically, this embodiment includes presetting a first temperature threshold and a first weight threshold for the third controller. For example, the first temperature threshold may range from 1400 to 2000 degrees, and specifically, may be 1400 degrees, 1500 degrees, 1600 degrees, 1700 degrees, 1800 degrees, 1900 degrees, or 2000 degrees. A specific value of the first temperature threshold may be set by persons skilled in the art based on their experience. For example, the first weight threshold may range from 50 g to 500 g, and specifically, may be 50 g, 60 g, 70 g, 80 g, 90 g, 100 g, 200 g, 300 g, 400 g, or 500 g. A specific value of the first weight threshold may be set by persons skilled in the art based on their experience.

A PC control terminal of the single crystal furnace may be connected to the temperature detection device 33, the first weight detection device, and the third controller, so that after a temperature collected by the temperature detection device 33 and/or a weight collected by the first weight detection device is fed back to the PC control terminal of the single crystal furnace, the PC control terminal may send an operation instruction to the third controller based on the preset first temperature threshold and/or first weight threshold. When the temperature fed back by the temperature detection device 33 is greater than the first temperature threshold, if the weight fed back by the first weight detection device is greater than the first weight threshold, the supply of the supplying device 4 is adjusted and reduced in real time by the third controller; and if the weight fed back by the first weight detection device is less than the first weight threshold, the power of the heating component 32 is adjusted and reduced in real time by the third controller.

When the temperature fed back by the temperature detection device 33 is greater than the first temperature threshold, and the weight fed back by the first weight detection device is greater than the first weight threshold, the supply from the supplying device 4 to the melting cavity 31 is large. In this case, a volume of the melt in the melting cavity 31 can be reduced by reducing the supply of the supplying device 4, to ensure that the melting cavity 31 supplies stable liquid material into the crucible 2, and ensure that a volume of liquid material in the crucible 2 is stable. When the temperature fed back by the temperature detection device 33 is greater than the first temperature threshold, and the weight fed back by the first weight detection device is less than the first weight threshold, the temperature in the melting cavity 31 is excessively high, and the melting cavity 31 conveys a large amount of material into the crucible 2. In this case, by reducing the power of the heating component 32, it can be ensured that the melting cavity 31 supplies stable liquid material into the crucible 2, and a volume of liquid material in the crucible 2 is stable.

When the weight fed back by the first weight detection device is greater than the first weight threshold, if the temperature fed back by the temperature detection device 33 is greater than the first temperature threshold, the supply of the supplying device 4 is adjusted and reduced in real time by the third controller. If the temperature fed back by the temperature detection device 33 is less than the first temperature threshold, the power of the heating component 32 is adjusted and reduced in real time by the third controller.

When the weight fed back by the first weight detection device is greater than the first weight threshold, and the temperature fed back by the temperature detection device 33 is greater than the first temperature threshold, the supply from the supplying device 4 to the melting cavity 31 is large. In this case, a volume of material in the melting cavity 31 can be reduced by reducing the supply of the supplying device 4, to ensure that the melting cavity 31 supplies stable liquid material into the crucible 2, and ensure that a volume of liquid material in the crucible 2 is stable. When the weight fed back by the first weight detection device is greater than the first weight threshold, and the temperature fed back by the temperature detection device 33 is less than the first temperature threshold, a volume of material in the melting cavity 31 is large, a melting rate is low, and the melting cavity 31 conveys a small amount of material into the crucible 2. In this case, by increasing the power of the heating component 32, it can be ensured that the melting cavity 31 supplies stable liquid material into the crucible 2, and a volume of liquid material in the crucible 2 is stable.

In an optional manner, in this embodiment, the first controller may preset a plurality of levels of temperature thresholds, for example, may set a first temperature threshold and a second temperature threshold. The first temperature threshold may range from 1400 to 1500 degrees, and the second temperature threshold may range from 1500 to 2000 degrees. Specific values of the first temperature threshold and the second temperature threshold may be set by persons skilled in the art based on their experience. A PC control terminal of the single crystal furnace may be connected to the temperature detection device 33 and the first controller, so that after a temperature collected by the temperature detection device is fed back to the PC control terminal of the single crystal furnace, the PC control terminal may send an operation instruction to the first controller based on the preset first temperature threshold and second temperature threshold. The second controller may preset a plurality of levels of weight thresholds, for example, may set a first weight threshold and a second weight threshold. The first weight threshold may range from 50 g to 200 g, and the second weight threshold may range from 200 g to 500 g. Specific values of the first weight threshold and the second weight threshold may be set by persons skilled in the art based on their experience. A PC control terminal of the single crystal furnace may be connected to the first weight detection device and the second controller, so that after a weight collected by the weight detection device is fed back to the PC control terminal of the single crystal furnace, the PC control terminal may send an operation instruction to the second controller based on the preset first weight threshold and second weight threshold.

The first controller adjusts the supply of the supplying device 4 and/or the power of the heating component 32 in real time based on the temperature fed back by the temperature detection device 33. Specifically, the supply of the supplying device 4 and the power of the heating component 32 are related to at least two temperature thresholds, and different temperature thresholds correspond to different supplies of the supplying device 4 and different powers of the heating component 32. The first controller accurately adjusts the supply of the supplying device 4 and/or the power of the heating component 32 by comparing relationships between the temperature fed back by the temperature detection device 33 and the at least two temperature thresholds. The second controller adjusts the supply of the supplying device 4 and/or the power of the heating component 32 in real time based on the weight fed back by the first weight detection device. Specifically, the supply of the supplying device 4 and the power of the heating component 32 are related to at least two weight thresholds, and different weight thresholds correspond to different supplies of the supplying device 4 and different powers of the heating component 32. The second controller accurately adjusts the supply of the supplying device 4 and the power of the heating component 32 by comparing relationships between the weight fed back by the first weight detection device and the at least two weight thresholds, to implement multi-level control of the power of the heating component 32 and multi-level control of the supply of the supplying device 4, and improve temperature control accuracy of the heating component 32 and supply control accuracy of the supplying device 4, so that the second controller can accurately control a liquid level of liquid material in the crucible 2, thereby ensuring that monocrystalline silicon has good growth quality.

### Embodiment 4:

This embodiment differs from Embodiment 1 in that: The liquid feeding device in this embodiment further includes a cooling device, and the cooling device is arranged on a side portion or a bottom portion of the melting cavity 31. With this structure, the melting cavity 31 can be cooled by the cooling device, so that a temperature in the melting cavity 31 can be accurately controlled, and a cooling speed of the melting cavity 31 can be increased. In this embodiment, the cooling device is preferably a gas cooling device, and includes a cooling pipe 34 for circulating cooling gas.

In an optional manner, the liquid feeding device further includes a flow control system and a fourth controller. The flow control system is configured to control a flow of the cooling device, thereby controlling a cooling rate of the cooling device. The fourth controller is connected to the flow control system and the supplying device 4 and/or the heating component 32, and configured to adjust a supply of the supplying device 4 and/or a power of the heating component 32 and/or a flow of the flow control system in real time based on a temperature in the melting cavity 31 and/or a weight of the melt in the melting cavity 31. With this structure, the fourth controller may adjust, based on the temperature fed back by the temperature detection device 33 and/or the weight fed back by the first weight detection device, the supply of the supplying device 4 in real time to adjust the volume of the material in the melting cavity 31, and adjust the power of the heating component 32 and/or the flow of the flow control system in real time to adjust the temperature in the melting cavity 31, thereby accurately controlling liquid material conveyed from the melting cavity 31 into the crucible 2, and ensuring that a volume of liquid material in the crucible 2 is stable.

Specifically, this embodiment includes presetting a first flow threshold for the fourth controller. For example, the first flow threshold may range from 5 L/min to 80 L/min, and specifically, may be 6 L/min, 7 L/min, 8 L/min, 9 L/min, 10 L/min, 20 L/min, 30 L/min, 40 L/min, 50 L/min, 60 L/min, 70 L/min, or 80 L/min. A specific value of the first flow threshold may be set by persons skilled in the art based on their experience. A PC control terminal of the single crystal furnace may be connected to the flow control system and the fourth controller, so that after a temperature collected by the temperature detection device 33 and/or a weight value collected by the first weight detection device is fed back to the PC control terminal of the single crystal furnace, the PC control terminal may send an operation instruction to the fourth controller based on the preset first flow threshold, to control the flow of the flow control system through the fourth controller.

When the temperature fed back by the temperature detection device 33 is greater than the first temperature threshold, and the flow controlled by the flow control system is less than the first flow threshold, a temperature in the melting cavity 31 is excessively high, a cooling rate of the cooling device is low, a melting rate of material in the melting cavity 31 is high, the melting cavity 31 supplies too much liquid material to the crucible 2, and a liquid level of liquid material in the crucible 2 rises. In this case, by adjusting and increasing the flow of the flow control system in real time, the cooling rate of the cooling device can be increased, thereby reducing the temperature in the melting cavity 31, and ensuring that the temperature in the melting cavity 31 is in a stable state.

When the temperature fed back by the temperature detection device 33 is less than the first temperature threshold, and the flow controlled by the flow control system is greater than the first flow threshold, a temperature in the melting cavity 31 is low, a cooling rate of the cooling device is high, a melting rate of material in the melting cavity 31 is low, the melting cavity 31 supplies a little liquid material to the crucible 2, and a liquid level of liquid material in the crucible 2 drops. In this case, by adjusting and reducing the flow of the flow control system in real time, the cooling rate of the cooling device can be reduced, thereby increasing the temperature in the melting cavity 31, and ensuring that the temperature in the melting cavity 31 is in a stable state.

When the weight fed back by the first weight detection device is greater than the first weight threshold, and the flow controlled by the flow control system is greater than the first flow threshold, there is too much melt in the melting cavity 31, and the cooling rate of the cooling device is high. In this case, by adjusting and reducing the flow of the flow control system in real time, the cooling rate of the cooling device can be reduced, thereby increasing the temperature in the melting cavity 31, increasing the melting rate of the melt in the melting cavity 31, and ensuring that the volume of the melt in the melting cavity 31 is in a stable state.

When the weight fed back by the first weight detection device is less than the first weight threshold, and the flow controlled by the flow control system is less than the first flow threshold, there is a little melt in the melting cavity 31, and the cooling rate of the cooling device is low. In this case, by adjusting and increasing the flow of the flow control system in real time, the cooling rate of the cooling device can be increased, thereby reducing the temperature in the melting cavity 31, to prevent the melt in the melting cavity 31 from causing, due to the high melting rate, too much liquid material to flow into the crucible 2, thereby ensuring that the volume of the melt in the melting cavity 31 is in a stable state.

In an optional manner, in this embodiment, the fourth controller may preset a plurality of levels of flow thresholds, for example, may set a first flow threshold and a second flow threshold. The first flow threshold may range from 5 to 40 L/min, and the second flow threshold may range from 40 to 80 L/min. Specific values of the first flow threshold and the second flow threshold may be set by persons skilled in the art based on their experience. A PC control terminal of the single crystal furnace may be connected to the flow control system and the fourth controller, so that after a temperature collected by the temperature detection device 33 and/or a weight value collected by the first weight detection device is fed back to the PC control terminal of the single crystal furnace, the PC control terminal may send an operation instruction to the fourth controller based on the preset first flow threshold and second flow threshold, to control the flow of the flow control system through the fourth controller.

In a possible implementation, the melting device 3 in at least one of the foregoing plurality of embodiments further includes a conduit 37. The conduit 37 is connected to the melting cavity 31. An end of the conduit 37 close to the single crystal furnace 1 is inclined downward relative to an other end thereof, so that liquid material in the conduit 37 can flow into the crucible 2 of the single crystal furnace 1 under the action of gravity, thereby ensuring that liquid material in the melting cavity 31 can be conveyed into the crucible 2. Alternatively, an end of the melting cavity 31 close to the crucible 2 is inclined downward relative to an other end thereof, so that liquid material in the melting cavity 31 and liquid material in the conduit 37 can flow into the crucible 2 under the action of gravity, thereby ensuring that the liquid material in the melting cavity 31 can be conveyed into the crucible 2. Alternatively, an end of the conduit 37 and an end of the melting cavity 31 that are close to the crucible 2 are inclined downward relative to other ends thereof, and liquid material in the melting cavity 31 and liquid material in the conduit 37 can flow into the crucible 2 under the action of gravity, thereby ensuring that the liquid material in the melting cavity 31 can be conveyed into the crucible 2. The conduit 37 and the melting cavity 31 may be an integral structure or may be separately arranged. In this embodiment, preferably, angles by which the conduit 37 and the melting cavity 31 are inclined downward are greater than 0° and less than or equal to 30°, for example, 1°, 2°, 3°, 4°, 5°, 6°, 7°, 8°, 9°, 10°, 11°, 12°, 13°, 14°, 15°, 16°, 17°, 18°, 19°, 20°, 21°, 22°, 23°, 24°, 25°, 26°, 27°, 28°, 29°, or 30°.

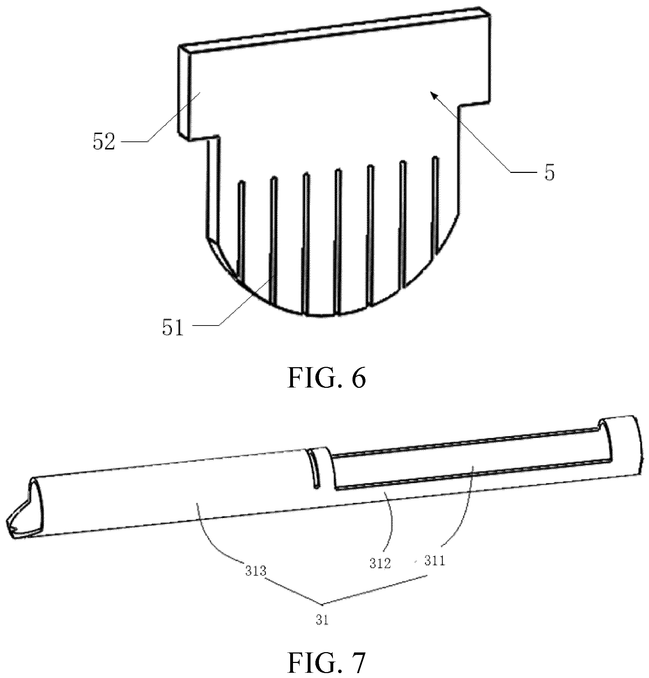

In addition, as shown in FIG. 6, in this embodiment, a baffle plate 5 may be arranged in the conduit 37 and/or the melting cavity 31, and a flow hole 51 for limiting passing of solid material and allowing passing of liquid material is provided in the baffle plate 5. A structure of the flow hole 51 may be meshed or may be a plurality of long holes arranged in parallel. Preferably, in this embodiment, the flow hole 51 is a long hole, and a plurality of flow holes 51 are arranged in parallel. An opening width of the flow hole 51 is less than a width of the solid material, to prevent passing of the solid material. The opening width of the flow hole 51 can be adjusted based on use requirements. A lower end of the baffle plate 5 is arranged to match an inner side of the melting cavity 31 or the conduit 37. An upper end of the baffle plate 5 is provided with a second positioning protrusion 52, a shell is provided with a second positioning groove matching the second positioning protrusion 52, and the baffle plate 5 can be mounted and positioned in a manner of snapping the second positioning protrusion 52 and the second positioning groove. Because solid material is placed in the melting cavity 31 for being heated and molten, solid material still exists in the melting cavity 31. By blocking the solid material with the baffle plate 5, liquid material in the crucible 2 can be prevented from oscillating and affecting growth of monocrystalline silicon when unmelted solid material in the melting cavity 31 flows into the crucible 2.

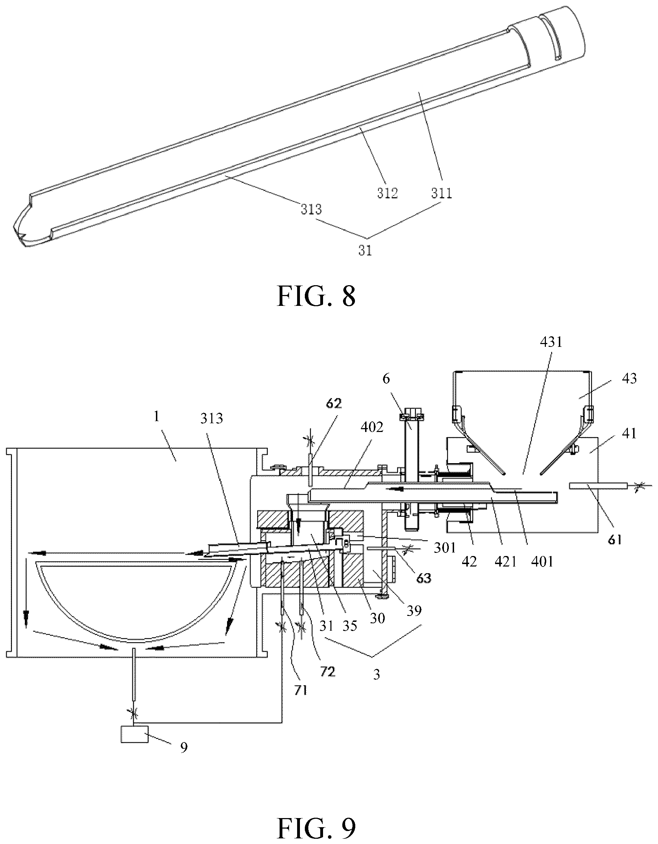

As shown in FIG. 7 and FIG. 8, the melting cavity 31 and the conduit 37 are an integral structure, including a melting section 312 and an export section 313. The melting section 312 includes a material inlet 311 for receiving solid material. The export section 313 includes a material outlet for extending into the single crystal furnace. The material outlet is provided with a notch for preventing the melt from flowing back along an outer wall of the conduit. The export section 313 includes a groove portion for mounting and matching the baffle plate 5. The material outlet is recessed toward a side of the melting section 312 to form a notch. The notch may be a concave-corner structure with a specific angle. In this case, the melt easily flows to a lower part of the material outlet along an edge of the notch under the action of gravity, thereby preventing the melt from flowing back along the outer wall of the conduit. The melting section 312 is higher than the export section 313, and solid material is melted into liquid material in the melting section 312 and flows to the crucible of the single crystal furnace through the baffle plate 5 and the export section 313.

In some embodiments, as shown in FIG. 8, both the melting section 312 and the export section 313 are in a groove shape. With this structure, solid material can be received and stored by using the groove-shaped melting section 312. In addition, the melting section 312 and the export section 313 have a simple structure, leading to convenient processing.

In some other embodiments, as shown in FIG. 7, the melting section 312 and/or the export section 313 is partially tubular, and the melting section 312 includes the material inlet in a groove shape. With this structure, not only solid material can be received by using the material inlet in a groove shape, but also strength of the melting section 312 or the export section 313 can be increased by using the tubular structure.

In an optional manner, the melting device 3 in at least one of the foregoing plurality of embodiments further includes a telescopic control mechanism 7 configured to control the conduit 37 and/or the melting cavity 31 to perform telescopic movement. The telescopic control mechanism 7 is a known mechanism that can implement telescopic control, for example, an electric telescopic push rod or a pneumatic telescopic push rod. When feeding is needed, the telescopic control mechanism 7 controls the conduit 37 and/or the melting cavity 31 to extend to the crucible 2 in the single crystal furnace 1 for feeding. When feeding is not needed, the telescopic control mechanism 7 controls the conduit 37 and/or the melting cavity 31 to telescope, to prevent the conduit 37 and the melting cavity 31, when in the single crystal furnace 1, from affecting operations, such as crystal pulling, reclaiming, and discharging, performed in the single crystal furnace 1. In addition, in this embodiment, in addition to controlling telescopic movement of the conduit 37 and/or the melting cavity 31, a lifting control mechanism configured to control lifting and lowering of the single crystal furnace 1 may be further arranged. By controlling lifting and lowering of the single crystal furnace 1 through the lifting control mechanism, it is convenient for the personnel to use the single crystal furnace 1 to perform operations such as crystal pulling, reclaiming, and discharging.

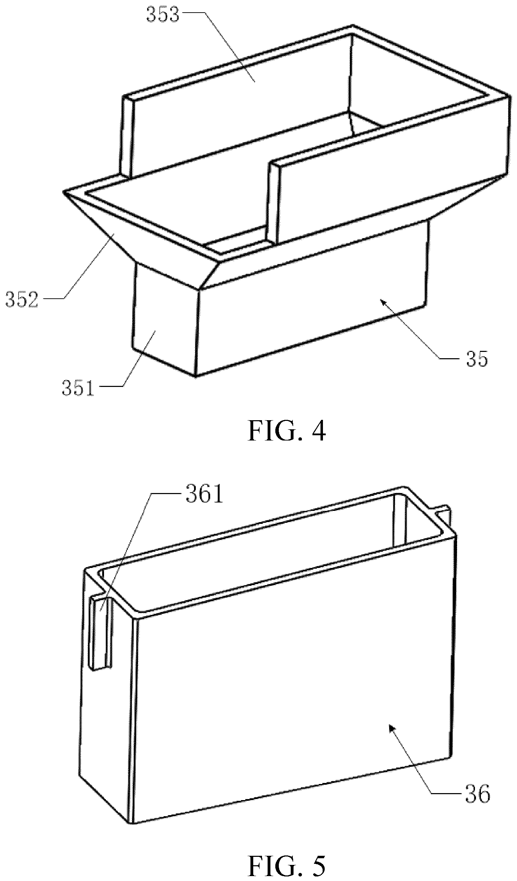

As shown in FIG. 4, the melting device 3 further includes a first guide pipe 35 configured to guide the solid material from the supplying device 4 into the melting cavity 31. An upper end of the first guide pipe 35 is funnel-shaped and has a surrounding plate 353 arranged to receive the solid material conveyed by the supplying device 4 and prevent the solid material from escaping from the first guide pipe 35. The first guide pipe 35 includes a pipe body 351 and a funnel portion 352. An opening area at an upper end of the funnel portion 352 is greater than an opening area at a lower end thereof, so that more solid material can be received. The surrounding plate 353 is a U-shaped surrounding plate 353, and includes an opening in communication with the supplying device 4 and a surrounding edge for blocking solid material to prevent the solid material from splashing out during conveying. The supplying device 4 conveys the solid material into the first guide pipe 35 through the opening of the surrounding plate 353. With this structure, heat radiation generated by the melting device 3 can be prevented from heating the solid material in the supplying device 4. In addition, the first guide pipe 35 may be made of a high temperature resistant material, to prevent heat radiation from the melting cavity 31 from affecting performance of the first guide pipe 35 and causing the first guide pipe 35 to soften.

In some embodiments, as shown in FIG. 5, the melting device 3 further includes a second guide pipe 36 having high temperature resistance. One end of the second guide pipe 36 is connected to the first guide pipe 35, and an other end thereof is in communication with the melting cavity 31, to guide the solid material in the first guide pipe 35 into the melting cavity 31. The second guide pipe 36 is made of a high temperature resistant material. A first positioning protrusion 361 is arranged on the second guide pipe 36. A sealed cavity 39 of the melting device 3 includes a shell configured to encapsulate and position the first guide pipe 35 and the second guide pipe 36. A first positioning snap groove matching the first positioning protrusion 361 is arranged on the shell, so that the second guide pipe 36 can be mounted and positioned on the shell. The first guide pipe 35 is in communication with the melting cavity 31 using the high temperature resistant second guide pipe 36, which can prevent a hot zone of the melting cavity 31 from affecting the first guide pipe 35 and causing the first guide pipe 35 to soften.

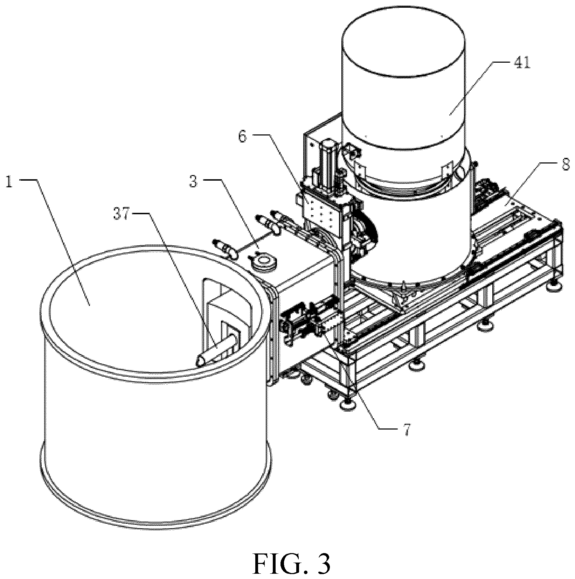

As shown in FIG. 2 and FIG. 3, the supplying device 4 in this embodiment includes a feed bin 41, a material conveying device 42, a second weight detection device 423, and a supply control system. The feed bin 41 is configured to store solid material, and the personnel convey solid material to the material conveying device 42 through the feed bin 41. The material conveying device 42 is configured to convey solid material, and includes a carrying component 421 and a driving component 422. The carrying component 421 is configured to carry solid material, and the driving component 422 is configured to drive the carrying component 421 to move to continuously convey solid material. The second weight detection device 423 is configured to detect a weight of solid material on the carrying component 421. Both the driving component 422 and the second weight detection device 423 are connected to the supply control system. The supply control system adjusts a driving speed of the driving component 422 in real time based on a detected value of the second weight detection device 423, to accurately control, by controlling a movement speed of the carrying component 421, a supply of solid material continuously conveyed by the supplying device 4 into the melting device 3. Preferably, in this embodiment, the carrying component 421 is a conveying pipe, the driving component 422 is a vibration mechanism, where the vibration mechanism is a known mechanism that can vibrate the conveying pipe to make material in the conveying pipe to move forward, and the second weight detection device 423 is a mechanism that can detect a weight of material in the conveying pipe.

It should be noted that the second weight detection device 423 and the first weight detection device may be the same weight detection device, or may be different weight detection devices, to achieve more accurate weight detection of solid material and liquid material. For example, when the second weight detection device 423 and the first weight detection device are the same weight detection device and both are the second weight detection device 423 configured to detect a weight of solid material on the carrying component 421, a weight of the melt in the melting cavity 31 may be inferred based on the weight fed back by the second weight detection device 423 and the conveying speed of the material conveying device 42. Alternatively, when the second weight detection device 423 and the first weight detection device are the same weight detection device and are both the first weight detection device configured to detect a weight of the melt in the melting cavity 31, a weight of solid material on the carrying component 421 may be inferred based on the weight fed back by the first weight detection device and the conveying speed of the material conveying device 42. Alternatively, when the second weight detection device 423 and the first weight detection device are different weight detection devices, a first weight of solid material on the carrying component 421 is detected by the second weight detection device 423, and a second weight of the melt in the melting cavity 31 is detected by the first weight detection device, weights of solid material and liquid material can be accurately measured respectively, and a material loss amount after the solid material is converted into the liquid material can be accurately measured by comparing differences between the first weight and the second weight. In addition, in this embodiment, the liquid feeding device further includes a base 8. The base 8 is configured to support the supplying device 4 and the melting device 3.

An embodiment of this application further provides a single crystal furnace, including the liquid feeding device according to the foregoing embodiment.

Compared with the related art, beneficial effects of the single crystal furnace provided in this embodiment are the same as the beneficial effects of the liquid feeding device for a single crystal furnace described in the foregoing embodiment, and details are not described herein again.

In a possible implementation, as shown in FIG. 1 and FIG. 2, the melting device 3 is integrally connected to the single crystal furnace 1. The single crystal furnace 1 further includes an isolation device 6. The melting device 3 includes a housing 38 integrally formed with the single crystal furnace 1 and a sealed cavity 39 located in the housing 38. The melting cavity 31 and the heating component 32 are located in the sealed cavity 39. The housing 38 includes a first opening in communication with the single crystal furnace 1 and a second opening in communication with the supplying device 4. The isolation device 6 is arranged at a position of the second opening, and configured to close the second opening when the supplying device 4 is removed, to cause the single crystal furnace 1 and the melting device 3 to be still in a sealed environment when the supplying device 4 is removed. With this structure, it can be ensured that the single crystal furnace 1 and the melting device 3 are in a well-sealed environment, to prevent an external environment from affecting growth of monocrystalline silicon, and improve a success rate of crystal pulling and quality of silicon ingots. The isolation device 6 is a known device that can seal the melting device 3 and the single crystal furnace 1 when the supplying device 4 is removed. In this embodiment, the isolation device 6 is preferably an isolation valve.

An embodiment of this application further provides a supplying method for a single crystal furnace. The single crystal furnace according to the foregoing solution is used. The method includes:
conveying solid material into the melting device through the supplying device; and
melting the solid material through the melting device to generate liquid material, and continuously conveying the liquid material into a crucible in the single crystal furnace to supply the liquid material.

Compared with the related art, beneficial effects of the supplying method for a single crystal furnace provided in this embodiment are the same as the beneficial effects of the single crystal furnace described in the foregoing embodiment, and details are not described herein again.

In an optional manner, a supply of the supplying device or a power of the heating component is adjusted in real time based on a temperature in the melting device;
or
a supply of the supplying device or a power of the heating component is adjusted in real time based on a weight of the melt in the melting device;
   or
a supply of the supplying device or a power of the heating component is adjusted in real time based on a temperature in the melting device and a weight of the melt in the melting device. With this method, a volume of liquid material conveyed from the melting cavity to the crucible can be controlled, so that a liquid level of liquid material in the crucible is controlled, thereby preventing problems, such as breakage and poor growth, of monocrystalline silicon caused when the liquid level of the liquid material in the crucible vertically fluctuates, and improving growth quality of the monocrystalline silicon.

In some embodiments, a cooling device is arranged at a side portion or a bottom portion of the melting cavity. With this structure, the melting cavity is cooled through the cooling device, so that a temperature in the melting cavity can be further accurately controlled, thereby accurately controlling the liquid level of the liquid material in the crucible.

In some embodiments, a flow of the cooling device is adjustable. The supply of the supplying device, the power of the heating component, and/or the flow of the cooling device is adjusted in real time based on the temperature in the melting device and the weight of the melt in the melting device. With this method, a volume of liquid material conveyed from the melting cavity into the crucible can be accurately controlled by controlling a supply of the supplying device, a power of the heating component, and/or a flow of the cooling device, thereby accurately controlling a liquid level of the liquid material in the crucible, and ensuring growth quality of monocrystalline silicon.

It is known that when monocrystalline silicon ingots are obtained through crystal pulling, a crystal pulling production apparatus needs to be used. The crystal pulling production apparatus includes a single crystal furnace 1 and a feeding component. The feeding component is located outside the single crystal furnace 1 and configured to feed silicon material into the single crystal furnace 1. The single crystal furnace 1 is provided with an exhaust port. The exhaust port is connected to a vacuum generation device 9, and configured to maintain a negative-pressure sealed state in the single crystal furnace 1 during crystal pulling production.

However, during crystal pulling production, because the feeding component is in communication with the single crystal furnace 1 and is in a negative pressure sealed state, the feeding component continuously or intermittently feeds silicon material (which may be in a liquid state or a solid state) to the single crystal furnace 1. If solid silicon material is fed, a large amount of dust is generated during the feeding. After the solid silicon material is melted into liquid silicon material, the dust adheres to a surface of the liquid silicon material or is doped in the liquid silicon material, which adversely affects quality of crystal pulling, and also adheres to an inner wall of the apparatus, especially to an inner wall of a silicon material conveying channel, which easily causes channel blockage due to accumulation over time. In addition, silicon vapor is generated in a process of the melting solid silicon material into liquid silicon material in the single crystal furnace 1, and the silicon vapor adheres to a surface of the liquid silicon material or is doped in the liquid silicon material, which adversely affects quality of crystal pulling. If liquid silicon material is fed, a large amount of silicon vapor is generated during the feeding, and the silicon vapor adheres to a surface of the liquid silicon material or is doped in the liquid silicon material, which adversely affects quality of crystal pulling. Therefore, the dust and the silicon vapor need to be cleared in time to reduce adverse impact of the dust and the silicon vapor on quality of crystal pulling.

To resolve the foregoing technical problems, this application provides a crystal pulling production apparatus. Referring to FIG. 9, the crystal pulling production apparatus includes a single crystal furnace 1 and a feeding component. The feeding component is located outside the single crystal furnace 1, and configured to feed silicon material into the single crystal furnace 1. A gas inlet pipe is arranged on the feeding component. The gas inlet pipe is configured to introduce cleaning gas. The cleaning gas enters the single crystal furnace 1 through the feeding component.

In a case that the technical solution is used, in a process in which the feeding component performs feeding to the single crystal furnace 1, or before crystal pulling production, or during entire crystal pulling production, cleaning gas may be continuously introduced into the single crystal furnace 1 by using the gas inlet pipe. As the cleaning gas is exhausted from the exhaust port of the single crystal furnace 1, the cleaning gas can carry away the dust and silicon vapor, thereby reducing dust and silicon vapor falling on the surface of the liquid silicon material in the single crystal furnace 1, reducing dust adhered to an inner wall of the apparatus, reducing adverse impact of dust and silicon vapor on quality of crystal pulling, and increasing a success rate of crystal pulling.

The silicon vapor herein refers to gaseous silicon and another gaseous silicon-containing compound. The dust described herein is mixed dust, including silicon dust and other impurity dust.

In a possible implementation, referring to FIG. 9, the feeding component includes a melting device 3. The melting device 3 is configured to feed liquid silicon material into the single crystal furnace 1. The gas inlet pipe includes a second gas inlet pipe 62 and/or a third gas inlet pipe 63 arranged on the melting device 3. Solid silicon material may be fed into the melting device 3. After the melting device 3 melts the solid silicon material into liquid silicon material, the liquid silicon material is feed into the single crystal furnace 1. Alternatively, the melting device 3 only implements a forwarding function. That is, the melting device 3 is used to feed molten liquid silicon material to the single crystal furnace 1. In a case that the technical solution is used, if the melting device 3 needs to melt solid silicon material into liquid silicon material, cleaning gas introduced through the second gas inlet pipe 62 and/or the third gas inlet pipe 63 can be used to carry away dust generated when the solid silicon material is fed and silicon vapor generated when the solid silicon material is melted into the liquid silicon material. If the melting device 3 only forwards the liquid silicon material, the cleaning gas may carry away silicon vapor carried in the liquid silicon material. In addition, if cleaning gas is introduced into the second gas inlet pipe 62 and the third gas inlet pipe 63 are simultaneously, a flow of the cleaning gas may be increased, which helps carry more silicon vapor and dust away, reduce dust and silicon vapor falling in the single crystal furnace 1, and reduce dust adhered to an inner wall of the melting device 3.

In a possible embodiment, the melting device 3 includes a sealed cavity 39, a melting cavity 31, and a heating component. The melting cavity 31 is configured to hold solid silicon material and/or liquid silicon material. The melting cavity 31 is provided with a material outlet in communication with the single crystal furnace 1. The melting cavity 31 and the heating component are both located in the sealed cavity 39. The heating component is configured to heat and melt silicon material in the melting cavity 31. In a case that the technical solution is used, when the melting cavity 31 holds solid silicon material, the heating component may melt the solid silicon material into a liquid state, and when the melting cavity 31 holds liquid silicon material, the heating component may heat the solid silicon material to maintain a liquid state. The sealed cavity 39 can achieve heat insulation and sealing, and can further avoid scalding caused by accidental touching the heating component and the melting cavity 31.

In an example, the melting cavity 31 may be tubular, including a melting section and an export section. A material inlet 311 is located in the melting section. The melting section is located in the sealed cavity 39. The export section extends into the single crystal furnace 1. Liquid silicon material flows from the melting section to the export section, and then enters the single crystal furnace 1 from the export section. In this way, a connection structure between the melting device 3 and the single crystal furnace 1 can be simplified, which is convenient for liquid silicon material to enter the single crystal furnace 1 from the melting device 3. During specific use, the melting cavity 31 may be slightly inclined, and the melting section is higher than the export section, which is convenient for the liquid silicon material to flow to the single crystal furnace 1.

In an example, the second gas inlet pipe 62 is communicatively arranged at a top portion of the sealed cavity 39, and a gas outlet of the second gas inlet pipe 62 corresponds to the material inlet 311 of the melting cavity 31. It is convenient for cleaning gas introduced through the second gas inlet pipe 62 to enter the material inlet 311, to carry dust and silicon vapor away from the melting device 3.

In an example, the melting device 3 further includes a heat insulation member 30 located in the sealed cavity 39. The heat insulation member 30 is provided with an inner cavity. The melting cavity 31 and the heating component are both located in the inner cavity. The heat insulation member 30 is provided with an avoidance hole. The avoidance hole corresponds to the material inlet 311 of the melting cavity 31. In a case that the technical solution is used, silicon material enters the melting cavity 31 from the avoidance hole. The heat insulation member 30 can achieve heat insulation, which helps solid silicon material in the melting cavity 31 to be quickly and fully heated and melted into liquid silicon material by the heating component, or helps keep liquid silicon material in the melting cavity 31 in a liquid state.

In an example, the melting device 3 may include a first guide pipe 35. The first guide pipe 35 passes through the avoidance hole. Silicon material passes through the first guide pipe 35 to enter the melting cavity 31. The first guide pipe 35 may protect the heat insulation member 30, to prevent silicon material from polluting and wearing the heat insulation member 30 when passing through the avoidance hole, thereby prolonging a service life of the heat insulation member 30.

In an example, the third gas inlet pipe 63 is communicatively arranged on a side portion of the sealed cavity 39. The heat insulation member 30 is provided with a vent hole 301. An inner end of the vent hole 301 is in communication with the material inlet 311 of the melting cavity 31, and an outer end thereof corresponds to a gas outlet of the third gas inlet pipe 63. In a case that the technical solution is used, cleaning gas introduced through the third gas inlet pipe 63 enters the material inlet 311 of the melting cavity 31 through the vent hole 301, so that the cleaning gas can flush an inner wall of the melting cavity 31, carry silicon vapor and dust away from the melting cavity 31, and improve cleanliness in the melting cavity 31.

In a possible implementation, the crystal pulling production apparatus further includes a cooling device. The cooling device is arranged on a side portion or a bottom portion of the sealed cavity 39. In a case that the technical solution is used, the melting cavity 31 is close to the heating component, a temperature in the melting cavity 31 is higher than a temperature of silicon material in the melting cavity, and the melting cavity 31 is likely to soften due to an excessively high temperature thereof. Therefore, the cooling device can cool down a side wall of the melting cavity 31 in the sealed cavity 39. A cooling capacity of the cooling device can be adjusted, to keep the melting cavity 31 in a proper temperature range, thereby avoiding softening of the melting cavity 31 caused by an excessively high heating temperature while ensuring that silicon material in the melting cavity 31 has a temperature higher than a melting point of the silicon material and can be quickly melted.

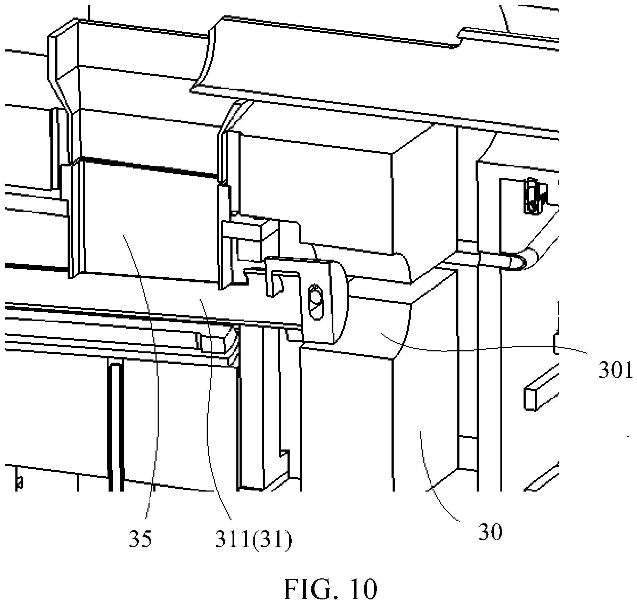

In a possible embodiment, referring to FIG. 9 and FIG. 10, the cooling device includes a cooling gas inlet pipe 71 and a cooling gas outlet pipe 72. The cooling gas inlet pipe 71 and the cooling gas outlet pipe 72 both extend into the sealed cavity 39. The cooling gas inlet pipe 71 is configured to introduce cooling gas. The cooling gas outlet pipe 72 is configured to exhaust the cooling gas. In a case that the technical solution is used, a flow of cooling gas can be adjusted, so that the cooling gas enters the sealed cavity 39 to cool down a side wall of the melting cavity 31, to keep the melting cavity 31 in a proper temperature range, thereby avoiding softening of the melting cavity 31 caused by an excessively high heating temperature while reducing impact on a temperature of silicon material in the melting cavity 31 as much as possible to ensure that the silicon material in the melting cavity 31 has a temperature higher than a melting point of the silicon material and can be quickly melted. Both the cooling gas inlet pipe 71 and the cooling gas outlet pipe 72 may extend below the melting cavity 31, so that cooling gas can be quickly exhausted through the cooling gas outlet pipe 72, and flowing of the cooling gas in the melting device 3 can be reduced, thereby reducing or avoiding cooling gas entering the melting cavity 31. In an example, both the cooling gas inlet pipe 71 and the cooling gas outlet pipe 72 may extend from a bottom portion of the sealed cavity 39, and their respective gas outlets correspond to a bottom wall of the melting cavity 31.

For example, in the apparatus, a melting temperature of solid silicon material is 1410°C, a maximum temperature that the melting cavity 31 can withstand is 1700°C, and the silicon material may be heated to 1500°C to 1600°C to ensure quick melting of the solid silicon material. Then, a temperature of a lower side wall of the melting cavity 31 may be controlled, by using cooling gas, to range from 1500°C to 1700°C or from 1600°C to 1700°C.

Further, when the melting device 3 includes the foregoing heat insulation member 30, the cooling gas inlet pipe 71 and the cooling gas outlet pipe 72 may both extend into an inner cavity of the heat insulation member 30.

In a possible implementation, the feeding component includes a supplying device. The supplying device is configured to feed solid silicon material into the single crystal furnace 1, and the gas inlet pipe includes a first gas inlet pipe 61 located on the supplying device. In a case that the technical solution is used, cleaning gas introduced through the first gas inlet pipe 61 first enters the supplying device, and can blow solid silicon material in the supplying device to carry away dust adhered to the solid silicon material. Dust generated in a process in which the solid silicon material is fed into the single crystal furnace 1 and silicon vapor generated during melting of the solid silicon material in the single crystal furnace 1 may also be carried away by the cleaning gas introduced through the first gas inlet pipe 61, and be exhausted from the single crystal furnace 1 together with the cleaning gas.

In a possible embodiment, referring to FIG. 9, the supplying device includes a feed bin 41 and a material conveying device 42. The material conveying device 42 has two ends in communication with the feed bin 41 and the single crystal furnace 1 respectively, and is configured to convey solid silicon material from the feed bin 41 to the single crystal furnace 1. The first gas inlet pipe 61 is communicatively arranged at a side portion of the feed bin 41, and the cleaning gas enters the single crystal furnace 1 through the material conveying device 42. In a case that the technical solution is used, solid silicon material in the feed bin 41 is transferred on the material conveying device 42, and is conveyed to the single crystal furnace 1 through the material conveying device 42. Cleaning gas introduced through the first gas inlet pipe 61 first enters the feed bin 41, then enters the material conveying device 42 from the feed bin 41, and enters the single crystal furnace 1 through a silicon material conveying channel of the material conveying device 42. In a process in which solid silicon material is placed in the material conveying device 42 and enters the single crystal furnace 1 from the material conveying device 42, generated dust may be carried by cleaning gas and exhausted from the single crystal furnace 1, so that dust falling on a surface of liquid silicon material in the single crystal furnace 1 can be reduced, thereby reducing adverse impact on quality of crystal pulling. Silicon vapor generated when solid silicon material is melted into a liquid state in the single crystal furnace 1 may also be carried away by cleaning gas.

In an example, the material conveying device 42 has a feeding position 401 and a dropping position 402. The feeding position 401 is located in the feed bin 41, and the dropping position 402 corresponds to the single crystal furnace 1. The supplying device further includes a hopper 43. The hopper 43 is arranged on the feed bin 41, and the hopper 43 is provided with a discharge port 431. The discharge port 431 is spaced apart above the feeding position 401 in a direction of gravity. The solid silicon material falls freely from the discharge port 431 to the feeding position 401, is conveyed by the material conveying device 42, and enters the single crystal furnace 1 from the dropping position 402.

In an example, a gas outlet of the first gas inlet pipe 61 may correspond to the charging position 401. Further, a height position of the gas outlet may be located between the feeding position 401 and the discharge port 431, so that dust generated during falling of solid silicon material from the discharge port 431 of the hopper 43 to the feeding position 401 is carried into the silicon material conveying channel of the material conveying device 42 to a maximum extent, so that dust is carried and exhausted out of the crystal pulling production apparatus as much as possible.

In a possible implementation, referring to FIG. 9, the feeding component includes a supplying device and a melting device 3. The supplying device conveys solid silicon material to the melting device 3. The melting device 3 melts the solid silicon material into liquid silicon material and conveys the liquid silicon material into the single crystal furnace 1. The gas inlet pipe includes at least one of a first gas inlet pipe 61, a second gas inlet pipe 62, and a third gas inlet pipe 63. The first gas inlet pipe 61 is located on the supplying device, and the second gas inlet pipe 62 and the third gas inlet pipe 63 are located on the melting device 3. In a case that the technical solution is used, cleaning gas introduced into any one of the foregoing three gas inlet pipes can carry away dust generated during conveying of solid silicon material and silicon vapor generated when the solid silicon material is melted into liquid silicon material. When there are two or three gas inlet pipes, cleaning gas has a large flow and can carry away more silicon vapor and dust, thereby preventing dust from adhering to liquid silicon material and an inner wall of the apparatus, and improving cleanliness in the crystal pulling production apparatus.

In an embodiment, referring to FIG. 9, the supplying device includes a feed bin 41 and a material conveying device 42. The material conveying device 42 has two ends in communication with the feed bin 41 and the melting device 3 respectively, and is configured to convey solid silicon material to the melting device 3. In a case that the technical solution is used, solid silicon material is placed on the material conveying device 42 in the feed bin 41, and the solid silicon material is conveyed to the melting device 3 by using the material conveying device 42. During crystal pulling production, solid silicon material may be conveyed to the melting device 3 in advance and heated and melted by using the melting device 3 to obtain liquid silicon material, and then the liquid silicon material is conveyed to the single crystal furnace 1 by using the melting device 3 at any time as required. In this way, time can be saved, and efficiency of crystal pulling can be improved.

It should be clarified that the first gas inlet pipe 61 is for carrying away dust of solid silicon material, and the second gas inlet pipe 62 and the third gas inlet pipe 63 are for carrying away dust entering the melting device 3, to prevent the dust from adhering to an inner wall of the melting device 3. In an optional embodiment, only the second gas inlet pipe 62 and/or the third gas inlet pipe 63 is arranged, and dust adhered to an inner wall of the supplying device can be removed through regular cleaning and maintenance. That is, the material conveying device 42 may be withdrawn from the melting device 3 and be disassembled for cleaning the conveying channel, and the feed bin 41 may be opened for cleaning an inner wall of the feed bin 41.

In a possible embodiment, referring to FIG. 9, the supplying device further includes a hopper 43 arranged on the feed bin 41. The hopper 43 is provided with a discharge port 431. The feed bin 41, the material conveying device 42, the melting device 3, and the single crystal furnace 1 are in sequential communication in a silicon material conveying direction. The material conveying device 42 has a feeding position 401 and a dropping position 402. The feeding position 401 is located in the feed bin 41, and is spaced apart below the discharge port 431 in a direction of gravity. The dropping position 402 is located in the melting device 3, and the material conveying device 42 is configured to convey solid silicon material obtained in the feed bin 41 to the melting device 3. The melting device 3 heats and melts solid silicon material into liquid silicon material, and the single crystal furnace 1 receives the liquid silicon material. When solid silicon material falls from the discharge port 431 to the feeding position 401, dust is generated, and the dust enters the single crystal furnace 1 along a silicon material movement channel. The silicon material movement channel herein includes a conveying channel for solid silicon material and a conveying channel for liquid silicon material.

The hopper 43 may be a funnel-shaped melting cavity 31, which helps silicon material smoothly fall from the discharge port 431 to the feeding position 401.

In an example, the first gas inlet pipe 61 is communicatively arranged on a side portion of the feed bin 41. In a case that the technical solution is used, cleaning gas introduced through the first gas inlet pipe 61 first enters the feed bin 41, then enters the material conveying device 42 from the feed bin 41, and enters the single crystal furnace 1 through the material conveying device 42 and the melting device 3. In a process in which solid silicon material enters the material conveying device 42 and enters the single crystal furnace 1 from the material conveying device 42, generated dust may be carried away by cleaning gas, so that dust falling on a surface of liquid silicon material in the single crystal furnace 1 can be reduced, thereby reducing adverse impact on quality of crystal pulling. Silicon vapor generated when solid silicon material is melted into a liquid state in the single crystal furnace 1 may also be carried away by cleaning gas.

In an example, referring to FIG. 9, a gas outlet of the first gas inlet pipe 61 extends into the feed bin 41 and corresponds to the feeding position 401, and a gas outlet direction of the first gas inlet pipe 61 is along a silicon material conveying direction. In this way, cleaning gas introduced through the first gas inlet pipe 61 may enter the silicon material conveying channel from the feeding position 401, which helps carry away, as much as possible, dust generated when solid silicon material falls from the discharge port 431 to the feeding position 401. In this case, according to a first aspect, accumulation of dust in the production apparatus (especially in the silicon material conveying channel) can be reduced, thereby improving cleanliness in the crystal pulling production apparatus. According to a second aspect, dust falling on a surface of liquid silicon material in the single crystal furnace 1 can be reduced, thereby reducing adverse impact on quality of crystal pulling, and increasing a success rate of crystal pulling. According to a third aspect, silicon vapor generated in a process of the melting solid silicon material into liquid silicon material can also be carried away, to reduce or avoid silicon vapor entering the liquid silicon material in the single crystal furnace 1, thereby further reducing adverse impact on the quality of crystal pulling and increasing the success rate of crystal pulling.

Further, a height position of a gas outlet of the first gas inlet pipe 61 may be located between the feeding position 401 and the discharge port 431 in a direction of gravity, so that dust generated during falling of solid silicon material from the discharge port 431 of the hopper 43 to the feeding position 401 is carried into the silicon material conveying channel of the material conveying device 42 to a maximum extent, so that dust is carried and exhausted out of the crystal pulling production apparatus as much as possible.

In an example, the first gas inlet pipe 61 may be a straight pipe, and has an extending direction consistent with a direction of the silicon material conveying channel of the material conveying device 42.

In an embodiment, referring to FIG. 9, the melting device 3 includes a sealed cavity 39, a melting cavity 31, and a heating component. The melting cavity 31 is provided with a material inlet 311 and a material outlet that is in communication with the single crystal furnace 1. The melting cavity 31 and the heating component are both located in the sealed cavity 39. The heating component is configured to heat and melt silicon material in the melting cavity 31. The material conveying device 42 extends into the sealed cavity 39 and corresponds to the material inlet 311 of the melting cavity 31, to convey solid silicon material into the melting cavity 31. In a case that the technical solution is used, when the melting cavity 31 can receive solid silicon material from the material conveying device 42 and then melt the solid silicon material into a liquid state by using the heating component, the material inlet 311 of the melting cavity 31 may also directly receive liquid silicon material, and the heating component may heat the liquid silicon material to keep the liquid silicon material in the liquid state. The sealed cavity 39 can achieve heat insulation and sealing, and can further avoid scalding caused by accidental touching the heating component and the melting cavity 31.

In an example, the dropping position 402 of the material conveying device 42 may be spaced apart above the material inlet 311 of the melting cavity 31 in a direction of gravity. Solid silicon material falls into the melting cavity 31 from the material inlet 311, during which, however, dust is generated.

In an example, the second gas inlet pipe 62 is communicatively arranged at a top portion of the sealed cavity 39, and a gas outlet of the second gas inlet pipe 62 is in communication with the material inlet 311 of the melting cavity 31. In a case that the technical solution is used, cleaning gas introduced through the second gas inlet pipe 62 can directly enter the melting cavity 31, and flow toward the single crystal furnace 1 along the silicon material conveying channel in the melting cavity 31. In this case, dust entering the melting cavity 31 and silicon vapor generated in the melting cavity 31 can be carried away, and dust and silicon vapor falling on a surface of liquid silicon material in the single crystal furnace 1 can be reduced, thereby reducing adverse impact on quality of crystal pulling and increasing a success rate of crystal pulling.

In an example, a gas outlet of the second gas inlet pipe 62 extends into the sealed cavity 39 and corresponds to the dropping position 402, and a gas outlet direction of the second gas inlet pipe 62 is along a direction of gravity. With the technical solution, the sealed cavity 39 is in a sealed state, and cleaning gas introduced through the second gas inlet pipe 62 and cleaning gas introduced through the first gas inlet pipe 61 flow into the material inlet 311 of the melting cavity 31 along a silicon material conveying direction together (referring to arrows in FIG. 9). The gas outlet direction of the second gas inlet pipe 62 is along the direction of gravity, which further helps the cleaning gas introduced through the second gas inlet pipe 62 enter the material inlet 311, thereby helping, based on the cleaning gas introduced through the first gas inlet pipe 61, carry dust generated when solid silicon material falls from the dropping position 402 into the material inlet 311 (the dropping position 402 and the material inlet 311 are spaced apart in a direction of gravity) and silicon vapor generated in a process of the melting solid silicon material into liquid silicon material as much as possible, and both parts of cleaning gas enter the single crystal furnace 1, to increase a flow of cleaning gas passing through a surface of silicon liquid in the single crystal furnace 1, which helps reduce dust falling on the surface of the silicon liquid in the single crystal furnace 1.

Therefore, with the foregoing technical solution, not only accumulation of dust in an accommodating device and the single crystal furnace 1 can be further reduced to improve cleanliness of the accommodating device and the single crystal furnace 1, but also dust and silicon vapor falling into liquid silicon material can be further reduced, to further reduce adverse impact on the quality of crystal pulling, and increase the success rate of crystal pulling.

In an embodiment, referring to FIG. 9 and FIG. 10, the third gas inlet pipe 63 is communicatively arranged on a side portion of the sealed cavity 39, and a gas outlet of the third gas inlet pipe 63 is in communication with the material inlet 311 of the melting cavity 31. In a case that the technical solution is used, cleaning gas introduced through the third gas inlet pipe 63 can enter the material inlet 311 of the melting cavity 31, and can flush an inner wall of the melting cavity 31, improve cleanliness in the melting cavity 31, and carry silicon vapor and dust away from the melting cavity 31.

In an example, referring to FIG. 9 and FIG. 10, a gas outlet of the third gas inlet pipe 63 extends into the sealed cavity 39 and corresponds to the material inlet 311 of the melting cavity 31, a gas outlet direction of the third gas inlet pipe 63 is along the silicon material conveying direction, and the third gas inlet pipe 63 is configured to introduce cleaning gas. In a case that the technical solution is used, cleaning gas introduced through the third gas inlet pipe 63 enters the material inlet 311 of the melting cavity 31 through the vent hole 301, so that the cleaning gas can flush an inner wall of the melting cavity 31, carry silicon vapor and dust away from the melting cavity 31, and improve cleanliness in the melting cavity 31.

Based on that the cleaning gas introduced through the first gas inlet pipe 61 and/or the second gas inlet pipe 62 has flowed into the material inlet 311 along the silicon material conveying direction, after entering the melting device 3, cleaning gas introduced through the third gas inlet pipe 63 and the cleaning gas introduced through the first gas inlet pipe 61 and/or the second gas inlet pipe 62 flow into the material inlet 311 of the melting cavity 31 along the silicon material conveying direction together (referring to arrows in FIG. 9).

If the three parts of cleaning gas all enter the melting cavity 31 and the single crystal furnace 1, dust and silicon vapor accumulated between the melting cavity 31 and a gas outlet of the single crystal furnace 1 may be carried away as much as possible, and in addition, a flow of cleaning gas passing through a surface of liquid silicon material in the single crystal furnace 1 is increased, which helps reduce dust falling on the surface of the liquid silicon material in the single crystal furnace 1. Therefore, with the technical solution, not only accumulation of dust in an accommodating device and the single crystal furnace 1 can be further reduced to improve cleanliness of the accommodating device and the single crystal furnace 1, but also dust and silicon vapor falling into liquid silicon material can be further reduced, to further reduce adverse impact on the quality of crystal pulling, and increase the success rate of crystal pulling.

**In** a possible embodiment, referring to FIG. 9 and FIG. 10, the melting device 3 further includes a heat insulation member 30 located in the sealed cavity 39. The heat insulation member 30 is provided with an inner cavity. The melting cavity 31 and the heating component are both located in the inner cavity. With the technical solution, the heat insulation member 30 can achieve heat insulation, which helps keep the melting cavity 31 above a melting point temperature of silicon material, to ensure that solid silicon material in the melting cavity 31 is quickly and fully melted into liquid silicon material. The sealed cavity 39 can achieve heat insulation and sealing, and can further avoid scalding caused by accidental touching the heating component and the melting cavity 31.

**In** an example, the heating component may be a heat-radiation heating component, located below the melting cavity 31 and spaced apart from the melting cavity 31. The heating component may match a shape of the melting cavity 31, to better heat solid silicon material in the melting cavity 31 to melt the solid silicon material.

In an example, the heat insulation member 30 is provided with an avoidance hole. The avoidance hole corresponds to the material inlet 311 of the melting cavity 31, and silicon material enters the melting cavity 31 from the avoidance hole.

In a possible embodiment, referring to FIG. 9 and FIG. 10, the melting device 3 further includes a first guide pipe 35. The heat insulation member 30 is provided with an avoidance hole. The first guide pipe 35 passes through the avoidance hole and has one end corresponding to the material inlet 311 of the melting cavity 31 and an other end corresponding to the dropping position 402. With the technical solution, solid silicon material falls from the dropping position 402 of the material conveying device 42 into the first guide pipe 35, and can accurately enter the material inlet 311 of the melting cavity 31 under the guidance and limitation of the first guide pipe 35, so that solid silicon material is prevented from falling outside the melting cavity 31. In addition, the first guide pipe 35 may protect the heat insulation member 30, to prevent solid silicon material from polluting and wearing the heat insulation member 30 when passing through the avoidance hole, thereby prolonging a service life of the heat insulation member 30.

In an example, referring to FIG. 9 and FIG. 10, there is a gap between the material conveying device 42 and the heat insulation member 30, and an end portion of the first guide pipe 35 extends out of the avoidance hole and corresponds to the dropping position 402, which not only is conducive to ensuring that the solid silicon material completely enters the first guide pipe 35, but also reduce adverse impact of a high temperature on the material conveying device 42.

In an example, an end of the first guide pipe 35 facing the melting cavity 31 may have a shape the same as that of the material inlet 311 of the melting cavity 31, and may match a size of the material inlet 311 in a width direction (the direction is perpendicular to the silicon material conveying direction) of the material inlet 311, to facilitate docking between the first guide pipe 35 and the material inlet 311 of the melting cavity 31, so that solid silicon material can accurately enter the melting cavity 31.

In an example, referring to FIG. 9, in a length direction (the direction is consistent with the silicon material conveying direction) of the material inlet 311, a size of an end of the first guide pipe 35 facing the melting cavity 31 may be smaller than a size of the material inlet 311. In this case, the heat insulation member 30 may be snap-connected to two ends of the material inlet 311, and gas introduced through the third gas inlet pipe 63 may also enter the melting cavity 31 from an end portion of the material inlet 311.

In an example, referring to FIG. 10, a gas outlet of the third gas inlet pipe 63 extends into the sealed cavity 39. The heat insulation member 30 is provided with a vent hole 301. An inner end of the vent hole 301 is in communication with the material inlet 311 of the melting cavity 31, and an outer end thereof corresponds to a gas outlet of the third gas inlet pipe 63. In a case that the technical solution is used, cleaning gas introduced through the third gas inlet pipe 63 enters the material inlet 311 of the melting cavity 31 through the vent hole 301, so that the cleaning gas can flush an inner wall of the melting cavity 31, carry silicon vapor and dust away from the melting cavity 31, and improve cleanliness in the melting cavity 31. In a case that the technical solution is used, the vent hole 301 can help cleaning gas introduced through the third gas inlet pipe 63 enter the material inlet 311 of the melting cavity 31 through the vent hole 301, so that a force at which the cleaning gas flushes an inner wall of the melting cavity 31 can be increased, and cleanliness of the inner wall of the melting cavity 31 can be improved. The force at which cleaning gas flushes a surface of silicon material can be increased, so that silicon vapor and dust are carried away as much as possible.

In a possible implementation, referring to FIG. 9, the material conveying device 42 may include a carrying component 421. An end of the carrying component 421 extending into the feed bin 41 is provided with a first notch, and/or an end of the carrying component 421 extending into the sealed cavity 39 is provided with a second notch. With this technical solution, the arrangement of the first notch and the second notch can reduce the weight of the carrying component 421.

When the material conveying device 42 adopts a vibration feeding manner, the material conveying device 42 further includes a vibrator. The vibrator is drive-connected to the carrying component 421, and may drive the carrying component 421 to vibrate, to implement movement of solid silicon material in the carrying component 421, thereby completing conveying of the solid silicon material. Moreover, by reducing the weight of the carrying component 421, it can be ensured that the vibration pipe can effectively vibrate, to convey solid silicon material from the feeding position 401 to the dropping position 402.

The first notch may be located at an end portion of the carrying component 421, and corresponds to the discharge port 431 of the hopper 43, and a position of the first notch is the feeding position 401. **In** this way, it is also convenient for cleaning gas introduced through the first gas inlet pipe 61 to enter the carrying component 421. The second notch may be located at an end portion of the carrying component 421, and a position of the second notch is the dropping position 402. In this way, it is also convenient for cleaning gas introduced through the second gas inlet pipe 62 blow solid silicon material at the dropping position 402, and carry away dust as much as possible.

In a possible implementation, an end of the material conveying device 42 extending into the sealed cavity 39 is coated with a high temperature resistant coating. Because solid silicon material needs to be melted in the melting device 3, a temperature in the sealed cavity 39 is high. However, to reduce costs, the material conveying device 42 may be made of a common material (such as quartz). In this case, the material conveying device 42 can be protected by applying the high temperature resistant coating.

Alternatively, in another possible implementation, the material conveying device 42 may also be made of a high temperature resistant material.

In a possible embodiment, the melting device 3 further includes an isolation device 6. The melting device 3 is provided with an inlet. The isolation device 6 is mounted at the inlet. When the isolation device 6 is open, the supplying device extends into the melting device 3 through the inlet. When the supplying device exits the melting device 3, the isolation device 6 is closed. In a case that the technical solution is used, after completing conveying of solid silicon material, the supplying device can be caused to exit the melting device 3, thereby reducing adverse impact of a high temperature in the melting device 3 on the supplying device.

In an example, the inlet of the melting device 3 is in communication with the sealed cavity 39. When the isolation device 6 is open, the material conveying device 42 of the supplying device extends into the sealed cavity 39 through the inlet, and the dropping position 402 of the material conveying device 42 corresponds to the material inlet 311 of the melting cavity 31. When the material conveying device 42 exits the sealed cavity 39, the isolation device 6 is closed. In a case that the technical solution is used, after completing conveying of solid silicon material, the material conveying device 42 can be caused to exit the sealed cavity 39, thereby reducing adverse impact of a high temperature in the sealed cavity 39 on the material conveying device 42.

In an example, the material conveying device 42 is telescopic, which is convenient for the material conveying device 42 to extend into or exit the sealed cavity 39. When extending into the sealed cavity 39, the material conveying device 42 extends to above the melting cavity 31, and the dropping position 402 corresponds to the material inlet 311.

When the isolation device 6 is open, and the material conveying device 42 extends into the sealed cavity 39 through the inlet, cleaning gas may be introduced through the first gas inlet pipe 61, the second gas inlet pipe 62, and the third gas inlet pipe 63 simultaneously.

When the material conveying device 42 exits the sealed cavity 39, and the isolation device 6 is closed, the first gas inlet pipe 61 stops introducing cleaning gas, and the second gas inlet pipe 62 and the third gas inlet pipe 63 may continue introducing cleaning gas simultaneously.

Cleaning gas introduced through the first gas inlet pipe 61 may enter the material conveying device 42 from the feeding position 401, then be discharged from the dropping position 402, flow toward the material inlet 311 to enter the melting cavity 31, flow from the melting section toward the export section 313 in the melting cavity 31, enter the single crystal furnace 1, and finally be exhausted from the single crystal furnace 1. In a flowing process, the part of cleaning gas can carry away dust generated in a process of conveying solid material and silicon vapor generated in a process of the melting solid silicon material into liquid silicon material, and can further blow a surface of liquid silicon material in the single crystal furnace 1 (especially in the single crystal furnace 1), to reduce dust falling on the surface of the liquid silicon material, thereby increasing a success rate of crystal pulling.

Cleaning gas introduced through the second gas inlet pipe 62 may flow from the dropping position 402 toward the material inlet 311 to enter the melting cavity 31, flow from the melting section toward the export section 313 in the melting cavity 31, enter the single crystal furnace 1, and finally be exhausted from the single crystal furnace 1. In a flowing process, the part of cleaning gas can carry away dust generated in a process of conveying solid material and silicon vapor generated in a process of the melting solid silicon material into liquid silicon material, and can further blow a surface of liquid silicon material in the single crystal furnace 1 (especially in the single crystal furnace 1), to reduce dust falling on the surface of the liquid silicon material, thereby increasing a success rate of crystal pulling.

Cleaning gas introduced through the third gas inlet pipe 63 may flow from the vent hole 301 of the heat insulation member 30 toward the material inlet 311 to enter the melting cavity 31, flow from the melting section toward the export section 313 in the melting cavity 31, enter the single crystal furnace 1, and finally be exhausted from the single crystal furnace 1. In a flowing process, the part of cleaning gas can carry away dust generated in a process of conveying solid material and silicon vapor generated in a process of the melting solid silicon material into liquid silicon material, and can further blow a surface of liquid silicon material in the single crystal furnace 1 (especially in the single crystal furnace 1), to reduce dust falling on the surface of the liquid silicon material, thereby increasing a success rate of crystal pulling.

When the material conveying device 42 extends into the sealed cavity 39 through the inlet to continuously convey solid silicon material, the solid silicon material generates dust when both entering the feeding position 401 and leaving the dropping position 402, resulting in a large amount of dust. The three parts of cleaning gas simultaneously flow, leading to a large flow of gas, so that a large amount of dust can be carried away.

When the material conveying device 42 exits the sealed cavity 39, and the isolation device 6 is closed, only solid silicon material stored on the material conveying device 42 generates dust in a process of falling from the dropping position 402 to the material inlet 311, resulting in a small amount of dust. The two parts of cleaning gas introduced through the second gas inlet pipe 62 and the third gas inlet pipe 63 can carry a small amount of dust away.

In a possible implementation, referring to FIG. 9, the crystal pulling production apparatus further includes a vacuum generation device 9. Both the single crystal furnace 1 and the cooling gas outlet pipe 72 are connected to the vacuum generation device 9. With the technical solution, under the action of the vacuum generation device 9, the cleaning gas introduced through the first gas inlet pipe 61 can quickly enter the material conveying device 42, the cleaning gas introduced through the second gas inlet pipe 62 and the third gas inlet pipe 63 can quickly enter the melting cavity 31, and cooling gas can quickly enter the cooling gas outlet pipe 72 from the cooling gas inlet pipe 71, thereby reducing flowing of the cooling gas in the melting device 3, and reducing or avoiding the cooling gas entering the melting cavity 31. For example, the vacuum generation device 9 may be a vacuum pump.

In an example, the first gas inlet pipe 61, the second gas inlet pipe 62, and the third gas inlet pipe 63 may be connected to a same gas source. The cleaning gas may be nitrogen, hydrogen, argon, or helium.

In an example, referring to FIG. 9, a crystal pulling crucible is arranged in the single crystal furnace 1, and configured to hold liquid silicon material and perform crystal growth. There is a gap between the crucible and an inner wall of the single crystal furnace 1. The single crystal furnace 1 is provided with a gas outlet located on a bottom wall. The gas outlet is in communication with the vacuum generation device 9. The gas outlet is located at a bottom portion, which helps a gas flow pass through a surface of liquid silicon material and around the crucible, to carry away dust and silicon vapor on the surface of the liquid silicon material, and further carry away dust around the crucible.

According to the foregoing crystal pulling production apparatus, this application further provides a crystal pulling method. The crystal pulling method includes:
closing the crystal pulling production apparatus, to make the crystal pulling production apparatus in a preset low-pressure state;
continuously introducing cleaning gas by using the gas inlet pipe, and continuously exhausting the cleaning gas from the single crystal furnace 1, to maintain the preset low-pressure state;
feeding silicon material to the single crystal furnace 1 by using the feeding component, to perform crystal pulling; and
after the crystal pulling is completed, stopping introducing the cleaning gas.

In a case that the foregoing technical solution is used, by continuously introducing cleaning gas until crystal pulling is completed, dust and silicon vapor generated during the crystal pulling can be carried away as much as possible, thereby reducing adverse impact on the crystal pulling, and improving quality and a success rate of the crystal pulling.

In an example, the vacuum generation device 9 may be connected to the single crystal furnace 1 to continuously pump gas in the crystal pulling production apparatus, to keep the crystal pulling production apparatus in a preset low-pressure state, so that under the action of the vacuum generation device 9, cleaning gas is continuously exhausted from the single crystal furnace 1 to carry away dust and silicon vapor, thereby cleaning an interior of the crystal pulling production apparatus.

In an example, if the crystal pulling production apparatus includes at least one of the first gas inlet pipe 61, the second gas inlet pipe 62, and the third gas inlet pipe 63, when cleaning gas needs to be introduced, all the gas inlet pipes may be used to introduce the cleaning gas simultaneously, and a large flow of cleaning gas can carry away dust and silicon vapor as much as possible.

In an example, when the supplying device exits the melting device 3, communication between the supplying device and the single crystal furnace 1 is cut off, and cleaning gas introduced through the first gas inlet pipe 61 cannot enter the single crystal furnace 1. Therefore, the first gas inlet pipe 61 needs to be closed.

In an example, if the crystal pulling production apparatus includes a cooling device, when the melting cavity 31 is heated by using the heating component, the melting cavity 31 is cooled by using the cooling device, so that the melting cavity 31 is in a proper temperature range, to avoid softening of the melting cavity 31 caused by an excessively high heating temperature. Specifically, if the cooling device includes a cooling gas inlet pipe 71 and a cooling gas outlet pipe 72, when the melting cavity 31 is heated by using the heating component, cooling gas is introduced by using the cooling gas inlet pipe 71, so that the melting cavity 31 is in a proper temperature range, to avoid softening of the melting cavity 31 caused by an excessively high heating temperature.

In the descriptions of the foregoing implementations, the described specific features, structures, materials, or characteristics may be combined in a proper manner in any one or more of the embodiments or examples.

The foregoing description is merely specific implementations of this application, but are not intended to limit the protection scope of this application. Any variation or replacement readily figured out by persons skilled in the art within the technical scope disclosed in this application shall fall within the protection scope of this application. Therefore, the protection scope of this application shall be subject to the protection scope of the claims.

## Claims

1. A liquid feeding device, used in a single crystal furnace, comprising:
a melting device, comprising a melting cavity and a heating component, wherein the heating component melts solid material in the melting cavity into liquid material; and
a supplying device, configured to convey solid material into the melting cavity.

2. The liquid feeding device according to claim 1, further comprising:
a temperature detection device, configured to detect a temperature in the melting cavity; and
a first controller, connected to the temperature detection device and the supplying device and/or the heating component, and configured to adjust a supply of the supplying device and/or a power of the heating component in real time based on a temperature fed back by the temperature detection device;
or
a first weight detection device, configured to detect a weight of the melt in the melting cavity; and
a second controller, connected to the first weight detection device and the supplying device and/or the heating component, and configured to adjust a supply of the supplying device and/or a power of the heating component in real time based on a weight fed back by the first weight detection device;
or
a temperature detection device, configured to detect a temperature in the melting cavity; and
a first weight detection device, configured to detect a weight of the melt in the melting cavity; and
a third controller, connected to the temperature detection device, the first weight detection device, and the supplying device and/or the heating component, and configured to adjust a supply of the supplying device and/or a power of the heating component in real time based on a temperature fed back by the temperature detection device and a weight fed back by the first weight detection device.

3. The liquid feeding device according to claim 1, further comprising a cooling device, wherein the cooling device is arranged on a side portion or a bottom portion of the melting cavity.

4. The liquid feeding device according to claim 3, further comprising:
a flow control system, configured to control a flow of the cooling device; and
a fourth controller, connected to the flow control system and the supplying device and/or the heating component, and configured to adjust a supply of the supplying device and/or a power of the heating component and/or a flow of the flow control system in real time based on a temperature in the melting cavity and/or a weight of the melt in the melting cavity.

5. The liquid feeding device according to claim 1, wherein the melting device further comprises a conduit, wherein the conduit is connected to the melting cavity, and an end of the conduit and/or an end of the melting cavity close to the single crystal furnace is inclined downward relative to an other end thereof.

6. The liquid feeding device according to claim 5, wherein the melting cavity and the conduit are an integral structure, comprising a melting section and an export section, wherein the melting section comprises a material inlet for receiving solid material, the export section comprises a material outlet for extending into the single crystal furnace, and the material outlet is provided with a notch for preventing the melt from flowing back along an outer wall of the conduit.

7. The liquid feeding device according to claim 6, wherein the melting section and the export section are both in a groove shape; or the melting section and/or the export section is partially tubular, and the melting section comprises the material inlet in a groove shape.

8. The liquid feeding device according to claim 5, wherein the melting device further comprises a telescopic control mechanism configured to control the conduit and/or the melting cavity to perform telescopic movement.

9. The liquid feeding device according to claim 1, wherein the melting device further comprises a first guide pipe, configured to guide the solid material from the supplying device into the melting cavity, wherein an upper end of the first guide pipe is funnel-shaped and has a surrounding plate arranged to receive the solid material conveyed by the supplying device and prevent the solid material from escaping from the first guide pipe.

10. The liquid feeding device according to claim 9, wherein the melting device further comprises a second guide pipe having high temperature resistance, wherein one end of the second guide pipe is connected to the first guide pipe, and an other end thereof is in communication with the melting cavity, to guide the solid material in the first guide pipe into the melting cavity.

11. A single crystal furnace, comprising the liquid feeding device according to any one of claims 1 to 10.

12. The single crystal furnace according to claim 11, wherein the single crystal furnace is integrally connected to the melting device.

13. The single crystal furnace according to claim 12, wherein the single crystal furnace further comprises an isolation device, the melting device comprises a housing integrally formed with the single crystal furnace and a sealed cavity located in the housing, the melting cavity and the heating component are located in the sealed cavity, the housing comprises a first opening in communication with the single crystal furnace and a second opening in communication with the supplying device, and the isolation device is arranged at a position of the second opening, and configured to close the second opening when the supplying device is removed, to cause the single crystal furnace and the melting device to be still in a sealed environment when the supplying device is removed.

14. The single crystal furnace according to claim 11, wherein a gas inlet pipe is arranged on the liquid feeding device, and configured to introduce cleaning gas, wherein the cleaning gas enters the single crystal furnace through the liquid feeding device.

15. The single crystal furnace according to claim 14, wherein the gas inlet pipe comprises a second gas inlet pipe and/or a third gas inlet pipe arranged on the melting device.

16. The single crystal furnace according to claim 15, wherein the melting device further comprises a sealed cavity, the melting cavity is provided with a material outlet in communication with the single crystal furnace, and both the melting cavity and the heating component are located in the sealed cavity.

17. The single crystal furnace according to claim 16, wherein the second gas inlet pipe is communicatively arranged at a top portion of the sealed cavity, and a gas outlet of the second gas inlet pipe corresponds to the material inlet of the melting cavity.

18. The single crystal furnace according to claim 16, wherein the melting device further comprises a heat insulation member located in the sealed cavity, wherein the heat insulation member is provided with an inner cavity, and the melting cavity and the heating component are both located in the inner cavity; and
the heat insulation member is provided with an avoidance hole, wherein the avoidance hole corresponds to the material inlet of the melting cavity.

19. The single crystal furnace according to claim 18, wherein the third gas inlet pipe is communicatively arranged a side portion of the sealed cavity, and the heat insulation member is provided with a vent hole, wherein an inner end of the vent hole is in communication with the material inlet of the melting cavity, and an outer end thereof corresponds to a gas outlet of the third gas inlet pipe.

20. The single crystal furnace according to claim 14, wherein the gas inlet pipe comprises a first gas inlet pipe located on the supplying device.

21. The single crystal furnace according to claim 20, wherein the supplying device comprises a feed bin and a material conveying device, wherein the material conveying device has two ends in communication with the feed bin and the single crystal furnace respectively, and is configured to convey solid silicon material from the feed bin to the single crystal furnace; and the first gas inlet pipe is communicatively arranged at a side portion of the feed bin, and the cleaning gas enters the single crystal furnace through the material conveying device.

22. The single crystal furnace according to claim 14, wherein the gas inlet pipe comprises at least one of a first gas inlet pipe, a second gas inlet pipe, and a third gas inlet pipe, wherein the first gas inlet pipe is located on the supplying device, and the second gas inlet pipe and the third gas inlet pipe are located on the melting device.

23. The single crystal furnace according to any one of claims 14 to 22, further comprising a vacuum generation device, wherein the single crystal furnace is connected to the vacuum generation device.

24. A supplying method for a single crystal furnace, wherein the single crystal furnace according to any one of claims 11 to 23 is used, and the method comprises:
conveying solid material into the melting device through the supplying device; and
melting the solid material through the melting device to generate liquid material, and conveying the liquid material into a crucible in the single crystal furnace to supply the liquid material.

25. The supplying method for a single crystal furnace according to claim 24, wherein
a supply of the supplying device or a power of the heating component is adjusted in real time based on a temperature in the melting device;
or
a supply of the supplying device or a power of the heating component is adjusted in real time based on a weight of the melt in the melting device;
or
a supply of the supplying device or a power of the heating component is adjusted in real time based on a temperature in the melting device and a weight of the melt in the melting device.

26. The supplying method for a single crystal furnace according to claim 25, wherein the cooling device is arranged on a side portion or a bottom portion of the melting cavity.

27. The supplying method for a single crystal furnace according to claim 26, wherein a flow of the cooling device is adjustable; and the supply of the supplying device, the power of the heating component, and/or the flow of the cooling device is adjusted in real time based on the temperature in the melting device and the weight of the melt in the melting device.

28. A crystal pulling method, wherein the single crystal furnace according to any one of claims 11 to 23 is used, and the crystal pulling method comprises:
closing the single crystal furnace, to make the single crystal furnace in a preset state;
continuously introducing cleaning gas by using the gas inlet pipe, and continuously exhausting the cleaning gas from the single crystal furnace, to maintain the preset state;
feeding silicon material to the single crystal furnace by using the feeding component, to perform crystal pulling; and
after the crystal pulling is completed, stopping introducing the cleaning gas.

29. The crystal pulling method according to claim 28, wherein when the single crystal furnace according to claim 23 is used, gas in the single crystal furnace is pumped by using the vacuum generation device, to make the single crystal furnace in the preset state.

30. The crystal pulling method according to claim 28, wherein if the single crystal furnace according to claim 21 is used, the cleaning gas is introduced by using at least one of the first gas inlet pipe, the second gas inlet pipe, and the third gas inlet pipe.

31. The crystal pulling method according to claim 28, wherein if the single crystal furnace according to claim 22 is used, the first gas inlet pipe is closed when the supplying device exits the melting device.

32. The crystal pulling method according to claim 28, wherein if the liquid feeding device according to claim 3 is used, when the melting cavity is heated by using the heating component, the melting cavity is cooled by using the cooling device.
